# EUROPÄISCHE PATENTSCHRIFT

(11) **EP 2 244 545 B1**
(45) Veröffentlichungstag und Bekanntmachung des Hinweises auf die Patenterteilung: **24.07.2013**
(21) Anmeldenummer: 10004291.0
(22) Anmeldetag: 22.04.2010
(51) Int. Cl.: H05K 7/14, H05K 3/36

(54) **Elektrische Verbindungseinrichtung**
Electrical connection device
Dispositif de raccordement électrique

(30) Priorität: 23.04.2009 DE 102009018663
(43) Veröffentlichungstag der Anmeldung: 27.10.2010
(73) Patentinhaber: Kathrein-Werke KG, 83022 Rosenheim (DE)
(72) Erfinder: Häntsch, Ralf, 83064 Raubling (DE)
(74) Vertreter: Flach, Dieter Rolf Paul

(56) Entgegenhaltungen:
- EP-A2- 1 418 798
- DE-A1- 19 728 291
- DE-A1- 19 735 426
- DE-B3-102007 029 524
- DE-C2- 19 735 409
- JP-A- 8 069 826
- JP-A- 9 147 940
- JP-A- 2004 079 975
- US-A- 5 239 135
- US-A- 5 500 789
- US-B1- 6 262 887
- US-B1- 6 347 044
- US-B1- 6 493 233
- US-B2- 7 345 247
- US-B2- 7 357 645

## Beschreibung

Die Erfindung betrifft eine elektrische Verbindungseinrichtung nach dem Oberbegriff des Anspruches 1.

Insbesondere bei Geräten der Hochfrequenztechnik (z.B. bei Verstärkern) müssen eine oder mehrere mit elektronischen Komponenten bestückte Leiterplatinen in einem elektrisch geschirmten Gehäuse untergebracht werden, damit die elektromagnetischen Wellen weder vom Inneren des Gehäuses nach außen noch umgekehrt von außen in das Innere des Gehäuses eindringen und dadurch Störungen verursachen können.

Die Leiterplatinen können dabei ein- oder beidseitig mit Baugruppen bestückt sein. Ebenso können die Leiterplatinen auch mehrschichtig bwz. mehrlagig ausgebildet sein, um die Bestückungsdichte noch zu erhöhen und/oder komplexere Leitungsstrukturen zu realisieren. In diesem Falle sind isolierende Zwischenschichten zwischen dem mehrlagigen Leiterplatinenaufbau vorgesehen.

Darüber hinaus erfordert die Schaltung auf der Leiterplatine in der Regel eine sehr gute Masseanbindung. Mit anderen Worten muss eine elektrisch gut leitfähige Masseanbindung der Leiterplatine an das die Leiterplatine aufnehmende Gehäuse realisiert sein. Dies erfolgt häufig über sehr viele, über die gesamte Oberfläche der Leiterplatine verteilte Kontaktpunkte, worüber die elektrische Kontaktierung zwischen der Leiterplatine zum einen und dem Gehäuse zum anderen erfolgt, damit vorzugsweise überall auf der Leiterplatine das gleiche Bezugspotential zur Verfügung steht.

Dabei sollen die entsprechenden Kontaktstellen nur einen geringen Kontaktwiderstand aufweisen.

Für die Verbindungstechnik zwischen der Leiterplatine zum einen und den die Leiterplatine aufnehmenden Halte- und Kontaktstellen in der Regel im Gehäuse zum Anderen sind unterschiedliche Kontakt- und mechanische Verankerungsmöglichkeiten bekannt geworden.

Aus der DE 197 28 291 A1 ist eine Verbindungseinrichtung als bekannt zu entnehmen, wobei das im Bereich einer Leiterplatinen-Öffnung zu verankernde Verbindungselement zum einen eine Grundfläche mit einem zentrischen Loch aufweist (aus einem elektrisch leitfähigen Material), wobei die Grundfläche dieses Kontakt- oder Verbindungselementes kleiner ist als die Ausnehmung der Leiterplatine und am Außenumfang der Grundfläche zumindest ein und vorzugsweise mehrere in Umfangsrichtung versetzt liegende Kontaktstifte vorgesehen sind, die quer und insbesondere senkrecht zur Ebene der Grundfläche wegstehen und in zusätzlichen Verankerungsbohrungen der Leiterplatine eingefügt werden. Über diese Kontaktstifte erfolgt eine mechanische und elektrisch-galvanische Verbindung mit der Leiterplatine. Die Herstellung und Verankerung dieses Verbindungselementes ist aber vergleichsweise aufwändig.

Entsprechend dreidimensional geformte Verbindungselemente sind auch aus einer Reihe weiterer Vorveröffentlichungen bekannt, beispielsweise aus der DE 197 35 426 A1 oder der US 7,357,645 B2, die ebenfalls mehrere Kontaktstifte aufweisen, die senkrecht zur Fläche des Grundelementes wegragen und in Umfangsrichtung versetzt liegend am Grundelement ausgebildet sind.

Ein kappenförmiges Verbindungselement mit innenliegender Ausnehmung, in welcher ein Zylinderzapfen eines Halteabschnittes eines Basiselementes eingreift, wird gemäß der US 6,262,887 B1 vorgeschlagen. Gemäß der EP 1 418 798 A2 (die sich mit einer völlig andersartigen Aufgabenstellung beschäftigt, nämlich der Verhinderung des Austritts von elektromagnetischer Strahlung) wird vorgeschlagen, dass bezüglich zweier parallel und mit Seitenversatz angeordneter Leiterplatinen eine gemeinsame Durchtrittsöffnung vorgesehen ist, die mit einer metallischen Beschichtung versehen ist, die jeweils an den gegenüberliegenden, nach außen weisenden Oberflächenseiten der Leiterplatinen mit einem auf der Leiterplatinenfläche umlaufenden flanschförmigen elektrisch leitförmigen Kontaktrand versehen ist. Auch hier kann ein Schraubglied in einen metallischen Verankerungszapfen eingedreht werden, so dass auch hier die Verpresskräfte letztlich auf die Leiterplatine wirken.

Eine gleiche Lösung wird auch in der US 5,500,789 A vorgeschlagen, ähnlich wie in der JP 08-069826 A oder der US 7,345,247 B2.

Aus der US 6,347,044 B1 ist lediglich eine mechanische Aufnahme und Befestigung einer Leiterplatine als bekannt zu entnehmen (wobei es hier nicht um die Problematik einer elektrischen Kontaktierung geht). Um die Leiterplatine innerhalb eines Notebooks in einem ausreichenden Abstand zur Bodenplatte montieren zu können, wird ein mit der Bodenplatte verbundener Sockel verwendet, auf welchem die Leiterplatine über einen Hülsenkörper mit umlaufenden Flansch gesetzt ist. Der Hülsenkörper ragt dabei in einer Ausnehmung in die Leiterplatine ein, wobei die Leiterplatine benachbart zu der Ausnehmung auf dem umlaufenden Flansch des hülsenförmigen Körpers aufliegt. Der umlaufende Rand der Bodenplatte des hülsenförmigen Körpers ist dabei mit der Leiterplatine verlötet. Über eine entsprechende Schraube, deren Schraubenkopf in den hülsenförmigen Körper eingreift, kann die Fixierung der Leiterplatine mechanisch an dem Abstandshalter gewährleistet werden.

Gemäß der DE 197 35 409 C2 wird beispielsweise vorgeschlagen, ein Kontaktelement mit einem oder mehreren federnden Kontaktfingern zu verwenden, die an den entsprechenden Kontaktstellen der Leiterplatine aufgelötet sind. Die so vorbereitete Leiterplatine kann dann auf entsprechende Kontaktstifte (die beispielsweise Teil des elektrisch leitfähigen Gehäuses sind) aufgesteckt werden, wobei sich dann die Kontaktzungen oder Kontaktfedern des auf der Leiterplatine aufgelöteten Kontaktelementes an den Gehäusestiften aufstellen und an deren Außenumfang unter Vorspannung schräg zulaufend einkerben und dadurch die elektrische Kontaktierung bewerkstelligen.

Soll die Leiterplatine aus dem Gehäuse demontierbar sein, werden in der Regel allerdings die Leiterplatinen über lösbare Schrauben an entsprechenden Halteabschnitten des Gehäuses verankert; wobei die Halteabschnitte in dem Gehäuse mit einem Innengewinde versehen sind, in die eine eine Bohrung der Leiterplatine durchsetzende Schraube eingedreht werden kann. Zwischen dem Schraubenkopf und der Anlagefläche des Leiterplatinen-Halteabschnittes (welcher Teil des elektrisch leitfähigen Gehäuses sein kann) ist die Leiterplatine mit eine die Durchtrittsöffnung für den Schraubenschaft umgebenden Leiterplatinen-Abschnitt fest geklemmt, wobei dieser Leiterplatinen-Abschnitt mit einer elektrisch leitfähigen Durchkontaktierung versehen ist. Das Innengewinde im Haltebereich ist nicht notwendig, wenn gewindeformende oder gewindeschneidende Schrauben verwendet werden. Dann ist eine auf den Schraubendurchmesser abgestimmte Bohrung im Halteabschnitt ausreichend. Entsprechende Grundprinzipien sind beispielsweise aus der US 6,493,233 B1 oder der US 5,500,789 A als bekannt zu entnehmen.

Zwischen dem Schraubenkopf und dem Gehäusedom (in welchem die die Leiterplatine fixierende Schraube eingedreht ist und an dessen Oberseite die Leiterplatine aufliegt) wirken dabei große Kräfte, wodurch eine hohe Flächenpressung erzeugt wird, die auf das Leiterplatten-Material einwirkt.

Eine insoweit dem gattungsbildenden Stand der Technik ebenfalls entsprechende Ausführungsform ist auch aus der JP 2004 079975 A bekannt geworden. Vorgeschlagen wird ein zylinderförmiger Kontaktkörper mit innenliegendem Axialgewinde, an derem einen Ende ein tellerförmiger, also flanschförmiger Rand radial übersteht. Der so gebildete zylinderförmige Körper kann in eine entsprechende Bohrung in einer Leiterplatine eingesetzt werden. Der Kontaktkörper stößt dann mit seinem radial überstehenden Rand oder Flansch auf einer Seite der Leiterplatine an, wo beispielsweise elektrisch leitfähige Kontaktbereiche ausgebildet sein können. Hier kann der flanschförmige Rand des Kontaktkörpers mit den dort befindlichen Kontaktflächen auf der Leiterplatine verlötet werden. In das Innengewinde des Kontaktkörpers kann eine Schraube eingedreht werden.

Obgleich diese Ausführungsform sehr häufig zum Einsatz kommt, ist es Aufgabe der vorliegenden Erfindung, hier eine deutliche Verbesserung zu schaffen, die auch langfristig nicht nur eine gute mechanische Fixierung der Leiterplatine auf einem Halteabschnitt, insbesondere eines die Leiterplatine aufnehmenden Gehäuses, gewährleistet. Dabei soll auch langfristig eine gute elektrische Kontaktierung zwischen entsprechenden elektrischen Kontaktstellen auf der Leiterplatine und dem elektrisch leitfähigen Leiterplatinen-Halteabschnitt beispielsweise in Form eines Gehäusedoms beibehalten werden.

Die Aufgabe wird erfindungsgemäß entsprechend den im Anspruch 1 angegebenen Merkmalen gelöst. Vorteilhafte Ausgestaltungen der Erfindung sind in den Unteransprüchen angegeben.

Im Rahmen der Erfindung hat sich gezeigt, dass die bisherige Lösung nach dem Stand der Technik Nachteile aufweist, die im Rahmen der herkömmlichen Befestigungsmethode nicht überwunden werden konnten.

Es hat sich nämlich im Rahmen der Erfindung gezeigt, dass die bisherige Befestigungsmethode unter Verwendung von Schrauben, zwischen denen und dem Auflager an einem Leiterplatinen-Halteabschnitt beispielsweise in Form eines Gehäusedoms derart hohe Flächenpressungen auf den zwischen Schraubenkopf und Auflagefläche des Haltedoms eingeklemmten Leiterplatinen-Abschnitt einwirken, die in der Regel die zulässigen Werte für eine Flächenpressung für die Leiterplatine überschreiten. Die Leiterplatine besteht dabei in der Regel aus einem Material wie beispielsweise glasfaserverstärktem Kunststoff (z.B. FR4 mit einem Glasfaseranteil von ca. 50 % und einem Restanteil von Epoxidharz). Durch die unzulässig hohe Flächenpressung wird eine zeitabhängige plastische Verformung bezüglich des eingepressten Leiterplatinen-Materials erzeugt, welches eine Tendenz zum Kriechen entwickelt. Da der Schraubenkopf üblicherweise aus Stahl besteht und beispielsweise das die Leiterplatine aufnehmende elektrisch leitfähige Gehäuse auch aus Stahl oder beispielsweise aus einem Metall-Guss oder einer Metall-Gusslegierung wie beispielsweise aus einer Aluminium-Gusslegierung bestehen kann, können diese Materialien die hohen Pressdrücke sehr wohl aufnehmen, nicht aber das Leiterplatinen-Material.

Die Leiterplatinen-Materialien haben dabei wie alle Kunststoffe die erwähnte Eigenschaft, bei hoher Flächenpressung (also bei einer Belastung senkrecht zur Flächenausdehnung), vor allem bei zunehmend höheren Temperaturen, noch stärker zu kriechen. Dabei ist zum Teil auch zu befürchten, dass bei hohen Belastungen teilweise sogar die Struktur des glasfaserverstärkten Kunststoffes zerstört wird, wobei sich das Harz von den Glasfasern ablösen kann. Ohne Bindung zu den Glasfasern hat jedoch das Harz eine noch höhere Kriechneigung. Dabei soll nur zur Vervollständigung angemerkt werden, dass die glasfaserverstärkten Leiterplatinen-Materialen im Gegensatz zu einer Belastung senkrecht zur Flächenausdehnung, also bei einer Belastung in Richtung der Flächenausdehnung, sehr viel höher belastbar sind und in dieser Flächenrichtung nur ganz geringe Kriechneigung feststellbar ist, wie man an den zahlreichen am Markt erhältlichen zuverlässig funktionierenden Einpresssteckverbindern für Leiterplatinen sieht. Dieser Vorteil kommt jedoch im vorliegenden Fall auf Grund der senkrecht zur Leiterplatine-Ebene wirkenden Kräfte nicht zum Tragen.

Durch das auftretende Kriechen des eingeklemmten Leiterplatinen-Materialabschnittes sinkt letztlich mit zunehmender Zeit die Kontaktkraft zwischen dem durchkontaktieren Leiterplatinen-Abschnitt und dem Auflage-Abschnitt an dem Leiterplatinen-Halteabschnitt (wie erwähnt in der Regel dem so genannten Gehäusedom) bzw. dem Schraubenkopf, wodurch gleichzeitig auch der elektrische Kontaktwiderstand stark ansteigt. Dadurch kann es zu Signalstörungen, insbesondere zu unerwünschten Intermodulationsprodukten kommen. Im Extremfall können bei zu hohen Druck-Belastungen durch zu fest eingedrehte Schrauben sogar die Durchkontaktierungen in den von den Schrauben durchsetzen Löchern in der Leiterplatine beschädigt werden. Mit anderen Worten verschlechtert sich der Kontakt bei der nach dem Stand der Technik bekannten Lösung, wobei zeitabhängig zusätzlich die Kontaktkraft weiter sinkt und dadurch nochmals zur Verschlechterung beiträgt.

Dabei ergibt sich zumindest implizit ein weiteres Problem insoweit, als die in der Leiterplatine durchkontaktierten Löcher zur Erzielung eines ausreichenden Korrosionsschutzes meist verzinnt sind, wobei Zinn ein relativ weicher Werkstoff ist, der ebenfalls bei hoher Flächenpressung zum Kriechen neigt.

Würde man demgegenüber versuchen die Schrauben weniger fest anzuziehen, um die zulässigen Drücke bei der Flächenpressung der Leiterplatine möglichst nicht zu überschreiten, ist man in der Regel mit einem neuen Problem konfrontiert. Denn man benötigt in der Regel hohe Kontaktkräfte, um sicher zu stellen, dass die isolierenden Oxid und/oder Fremdschichten bei den durchkontaktierten und in der Regel verzinnten, versilberten oder vergoldeten elektrisch leitfähigen Abschnitten im Bereich der von den Fixierschrauben durchsetzten Leiterplatinen und auf den am Kontakt beteiligten Gehäuse- sowie Schraubenflächen durchbrochen werden, um eine gute elektrische Kontaktierungswirkung zu realisieren.

Demgegenüber wird nunmehr erfindungsgemäß vorgeschlagen, die mechanische Fixierung auch zur Erzielung einer guten elektrischen Kontaktierung zwischen Leiterplatine und einem Auflager an einem Leiterplatinen-Halteabschnitt dadurch zu realisieren, dass die über die Schraube eingeleiteten Klemmkräfte nicht oder nicht maßgeblich auf das Material der Leiterplatine selbst einwirken, sondern dass an der Leiterplatine eine elektrisch leitfähige Kontaktiereinrichtung elektrisch und mechanisch angebracht wird, auf die die Presskräfte wirken, und die gegenüber dem herkömmlichen Leiterplatinen-Material sehr viel höheren Drücken Stand hält.

Alternativ zu den Schrauben können aber auch Nietzapfen verwendet werden, die am Gehäuse angeformt sind. Auch in diesem Fall wird die Leiterplatine durch das Nieten mechanisch nicht belastet. Es handelt sich in diesem Falle allerdings um eine unlösbare Verbindung.

Mit anderen Worten wird erfindungsgemäß eine Konktakteinrichtung oder ein zusätzliches Kontaktelement vorgeschlagen, das aus einem Material mit guter elektrischer Leitfähigkeit, hoher zulässiger Flächenpressung und geringer Kriechneigung besteht, und welches mit der Leiterplatine elektrisch und mechanisch verbunden ist. Somit wirken die hohen Flächenpresskräfte zwischen der Schraube und dem Auflager nicht auf das Material der Leiterplatine selbst, sondern auf ein zusätzlich vorgesehenes mit der leiterplatine elektrisch und mechanisch verbundenes Kontaktelement, so dass es zu dem im Stand der Technik auftretenden Kriechen des Leiterplatinenmaterials und damit zur Verschlechterung der elektrischen Kontaktwirkungen nicht mehr kommen kann.

So liegt beispielsweise die zulässige Flächenpressung bei Leiterplatinen-Materialien aus Kunststoff zwischen 10 bis 50 N/mm². Die zulässige Flächenpressung bei Schrauben oder Gehäuseteilen aus Metall, also die zulässige Flächenpressung bei Materialien wie Stahl, Aluminium-Guss etc. liegen häufig zwischen Werten von 200 bis 600 N/mm². Da die Flächenpressung bei Verwendung von Schrauben zur Fixierung der Leiterplatine in der Regel immer über 100 N/mm² liegen, werden die Nachteile nach dem Stand der Technik sicher vermieden, wenn als Kontakt- und Halteeinrichtung für die Leiterplatine, an welchem die hohen Verpresskräfte auftreten, eine Kontakteinrichtung oder ein Kontaktelement mit entsprechend hohen zulässigen Werten für die Flächenpressung verwendet wird, bevorzugt ebenfalls aus einem Metall, einer Legierung etc.

Im Rahmen der Erfindung lassen sich also hohe Kontaktkräfte bei einem konstanten Kontaktwiderstand über die gesamte Lebensdauer der so realisierten Verbindungseinrichtung aufrecht erhalten. Die erfindungsgemäße Kontakteinrichtung eignet sich vor allem auch bei hohen auftretenden thermischen Belastungen. Unerwünschte Störprodukte vor allem auch durch Intermodulation werden dabei im Rahmen der Erfindung sicher vermieden. Zudem können ungünstige Kontaktpaarungen zwischen dem Halteabschnitt des Gehäuses, beispielsweise dem aus einem Aluminium oder einem Aluminium-Guss bestehenden Gehäuse und den elektrisch leitfähigen Durchkontaktierungen an der Leiterplatine entschärft werden, vor allem dann, wenn die Durchkontaktierung zur Vermeidung von Korrosionen eine versilberte Oberfläche aufweist. Dadurch lassen sich unerwünschte große elektrochemische Potentialdifferenzen zwischen den verschiedenen Materialien vermeiden, wodurch die Gefahr der Kontaktkorrosion ebenfalls verringert wird.

Schließlich lässt sich die erfindungsgemäße Verbindungseinrichtung jederzeit lösen und beliebig oft wiederverwenden. Dabei können sogar im Rahmen der Erfindung Schrauben mit kleineren Durchmessern verwendet werden, da die dadurch bedingten noch höheren Flächenpress-Kräfte problemlos aufgenommen werden können.

Wird für das Kontaktelement ein Material verwendet, welches zusätzlich gute Wärmeleitereigenschaften besitzt, kann mit einer erfindungsgemäßen Verbindungseinrichtung auch effektiv Wärme von der Leiterplatine zum Gehäuseboden abgeleitet werden.

Die Erfindung wird nachfolgend anhand verschiedener Ausführungsbeispiele näher erläutert. Dabei zeigen im Einzelnen:
- Figur 1:: eine axiale Schnittdarstellung durch ein erstes erfindungsgemäßes Ausführungsbeispiel einer elektrischen Verbindungseinrichtung;
- Figur 1a:: eine schematische räumliche Darstellung auf eine Leiterplatine mit einer erfindungsgemäß vorgesehenen Kontakteinrichtung;
- Figuren 2 bis 4:: jeweils eine axiale Schnittdarstellung durch verschiedene Ausführungsbeispiele einer erfindungsgemäßen elektrischen Verbindungseinrichtung;
- Figur 5:: eine Draufsicht auf ein abgewandeltes Ausführungsbeispiel;
- Figuren 6 bis 9:: verschiedene Beispiele in räumlicher Ansicht für eine erfindungsgemäße Kontakteinrichtung für ein erfindungsgemäßes Kontaktelement;
- Figuren 10 bis 13:: drei weitere erfindungsgemäße Ausführungsbeispiele im axialen Querschnitt;
- Figur 14:: eine räumliche Darstellung einer Leiterplatine mit einem abgewandelten, erfindungsgemäßen Kontaktelement;
- Figur 14a:: ein in Figur 14 gezeigtes Kontaktelement in vergrößerter räumlicher Darstellung;
- Figur 15:: ein gegenüber Figur 14 abgewandeltes Ausführungsbeispiel mit zur Seite hin offenen Kontaktelementen;
- Figur 15a:: das in Figur 15 gezeigte Kontaktelement in vergrößerter Darstellung;
- Figur 16:: ein gegenüber Figuren 14 und 15 nochmals abgewandeltes Ausführungsbeispiel;
- Figur 16a:: das in Figur 16 gezeigte Kontaktelement in vergrößerter Einzeldarstellung; und
- Figur 17:: ein zu Figur 1 abgewandeltes Ausführungsbeispiel unter Verwendung eines Nietzapfens anstelle einer Schraube zur elektrischen Kontaktierung und Fixierung einer Leiterplatine.

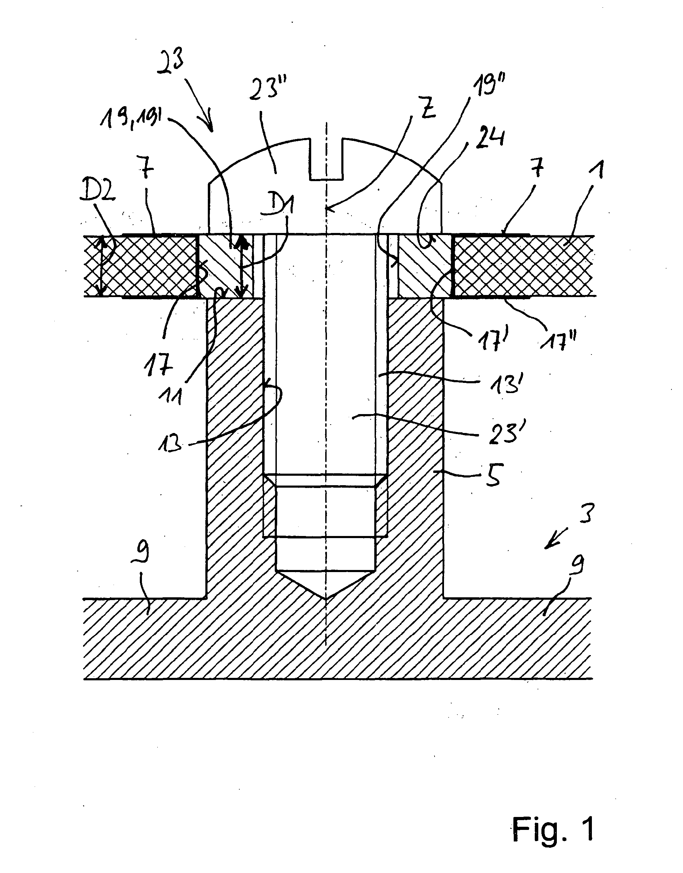

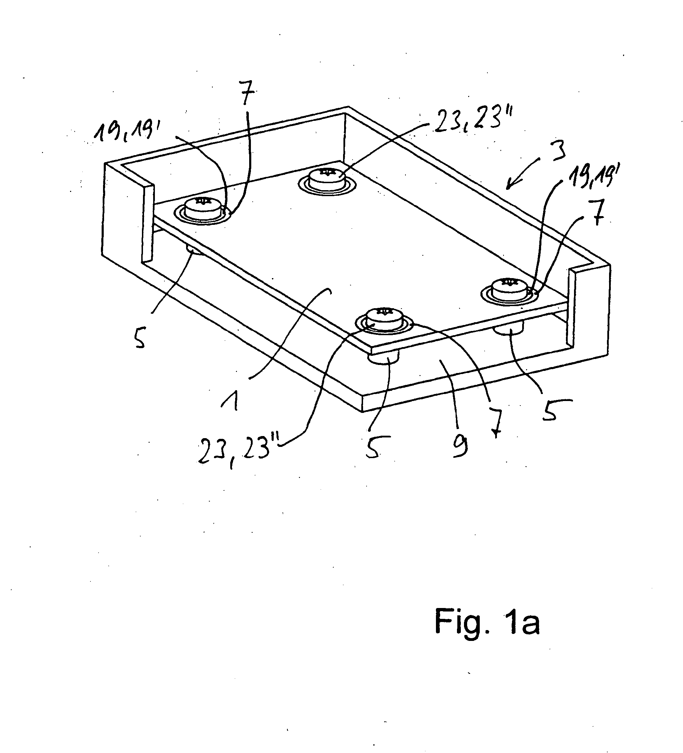

In Figur 1 ist im auszugsweisen schematischen Querschnitt eine Leiterplatine 1 gezeigt, die beispielsweise in einem Gehäuse 3 an mehreren Halteabschnitten 5 mechanisch verankert und gehalten werden soll und dabei soll eine gute elektrische Masse-Kontaktierung zwischen einem entsprechend leitfähigen Kontaktabschnitt 7 auf der Leiterplatine 1 und einem Träger oder Halteabschnitt 5 gewährleistet sein, der ebenfalls aus elektrisch leitfähigem Material, üblicherweise aus einem Metall, einem Druckguss-Teil etc. besteht. Eine oder mehrere dieser Halteabschnitte 5 (von denen in Figur 1 nur einer im Querschnitt gezeigt ist) können bevorzugt Teil des elektrisch leitfähigen Gehäuses 3 sein. In Figur 1 ist dazu im Querschnitt der Säulenoder domförmige Halteabschnitt 5 zu sehen, der untenliegend in den Boden 9 des nicht weiter dargestellten Gehäuses 3 übergeht.

Der Halteabschnitt 5 wird nachfolgend teilweise auch als Tragsäule oder Dom 5 bezeichnet. Er kann einen quadratischen, kreisförmigen oder einen sonstigen Querschnitt aufweisen. Obenliegend ist dieser Halteabschnitt 5 mit einer Auflagefläche 11 versehen. Der so gebildete Dom 5 weist eine Innenbohrung 13 mit einem Innengewinde 13' auf, wobei das Gewinde nicht notwendig ist, wenn gewindeformende und gewindeschneidende Schrauben verwendet werden.

Die Leiterplatine 1 weist eine entsprechende Ausnehmung 17 auf, in welche im gezeigten Ausführungsbeispiel eine Kontakteinrichtung 19 in Form eines Kontaktelementes 19' eingefügt ist. Im gezeigten Ausführungsbeispiel weist dieses Kontaktelement 19' eine Dicke D1 auf, die der Dicke D2 der Leiterplatine entspricht.

Um nicht nur die Leiterplatine 1 mechanisch fest am Dom 5 fixieren zu können, sondern um auch eine gute elektrische Verbindung zwischen dem leitfähigen Kontaktabschnitt 7 auf der Leiterplatine 1 und dem Halteabschnitt 5 (Dom 5) und damit insbesondere des erwähnten Gehäuses 3 herzustellen, ist die Ausnehmung 17 der Leiterplatine mit einer Durchkontaktierung 17' versehen, die üblicherweise in einen die Ausnehmung 17 auf der Unterseite der Leiterplatine noch mit umgebenden elektrisch leitfähigen Kontaktabschnitt 17" übergeht.

Vor dem Verankern der Leiterplatine 1 wird im gezeigten Ausführungsbeispiel das Kontaktelement 19' in die Ausnehmung 17 der Leiterplatine 1 eingepresst, und zwar bevorzugt nach dem Verlöten der elektrischen Bauteile auf der Leiterplatine 1. Die radialen Außenabmessungen der Kontakteinrichtung 19 bzw. des Kontaktelements 19' (welches in die Ausnehmung 17 der Leiterplatine 1 eingepresst ist) in Erstreckungsrichtung der Ebene der Leiterplatine 1, also quer oder senkrecht zur Zentralachse Z der Innengewindebohrung 13, sind im gezeigten Ausführungsbeispiel zumindest geringfügig größer als die radialen Außenabmessungen des bevorzugt im Querschnitt kreisförmigen Halteabschnittes 5 (Dom 5) und größer als die radialen Außenabmessungen des nachfolgend noch erwähnten Schraubenkopfes.

Die Fixierung der Leiterplatine erfolgt letztlich über eine in Figur 1 gezeigte Schraube 23 mit einem Schraubenschaft 23' mit einem Außengewinde und einem Fixieranschlag 24, der durch einen radialen Überstand über den Außendurchmesser des Schraubenschaftes 23' gebildet wird, im gezeigten Ausführungsbeispiel durch die Unterseite des Schraubenkopfes 23". Dabei ist auch die radiale Erstreckung und damit der Durchmesser des Schraubenkopfes 23" im gezeigten Ausführungsbeispiel kleiner als der Durchmesser des lochscheibenförmigen Kontaktelementes 19'.

Da das Kontaktelement 19' ebenfalls wie die Schraube 23 und der Schraubenkopf 23" und der auch als Dom 5 bezeichneten Halteabschnitt 5 aus Metall besteht, kann die Schraube nunmehr so fest durch die Ausnehmung bzw. das Loch 19" im Kontaktelement 19 hindurch in die Innengewindebohrung 13, 13' des Domes 5 eingedreht werden, so dass Flächenpressungskräfte zwischen der Schraubenkopfunterseite mit dem dadurch gebildeten Fixieranschlag 24 und der Oberseite des Kontaktelementes 19' bzw. zwischen der Unterseite des Kontaktelementes 19' und der Auflagefläche 11 des als Dom bezeichneten Halteabschnittes 5 deutlich höher liegen, als wenn zwischen Schraubenkopf und Auflagefläche 11 des Domes 5 die Leiterplatine 1 wie beim Stand der Technik eingeklemmt verankert werden würde. Die zulässigen Flächenpressungswerte p_{zul} können dabei mehr als 100 N/mm² betragen, beispielsweise mehr als 120, 140, 160, 180 oder sogar mehr als 200 N/mm² betragen. Insbesondere bei Stahl und Aluminium oder bei Verwendung eines Aluminium-Gusses für den Dom (und damit für das Gehäuse) können beispielsweise zulässige Flächenpressungswerte P_{zul} realisiert werden, die zwischen 200 bis 600 N/mm² liegen. Ganz allgemein wird das Material für die Kontakteinrichtung 19 sowie des Kontaktelements 19' so gewählt, dass die zulässige Flächenpressung für die Kontakteinrichtung 19 bzw. des Kontaktelements 19' mehr als 20 %, insbesondere mehr als 40 %, mehr als 60 %, mehr als 80 % oder mehr als 100 % über der zulässigen maximalen Flächenpressung für das Leiterplatinen-Material liegt.

Durch den Presssitz des Kontaktelementes 19 in der Ausnehmung 17 der Leiterplatine ist hier ein ausreichend fester mechanischer Klemmsitz oder Presssitz gewährleistet, so dass durch die Verpressung des Kontaktelementes 19, bestehend aus einem Metallelement, auch die Leiterplatine entsprechend ausreichend fest fixiert ist. Durch die verwendete Durchkontaktierung wird zudem eine perfekt leitende elektrische Verbindung zwischen dem elektrisch leitfähigen Kontaktabschnitt 7 und über die Durchkontaktierung 17' zu dem in die Ausnehmung eingepressten Kontaktelement 19' und darüber zu dem Dom 5 gewährleistet, also zu dem auf Massepotential liegenden elektrisch leitfähigen Gehäuse 3.

Anhand von Figur 1a ist in räumlicher Darstellung ein Teil des Gehäuses 3 mit beispielsweise vier Domen 5 gezeigt, worüber die Leiterplatine 1 im Abstand oberhalb des Bodens 9 des Gehäuses 3 gehalten ist. An den Befestigungsstellen sind jeweils kreisförmige leitende Kontaktabschnitte 7 zu ersehen, wobei in den entsprechenden Durchtrittsöffnungen in der Leiterplatine dann die Kontakteinrichtung 19 in Form von Kontaktelementen 19' eingesetzt sind. Über die eingedrehten Schrauben ist ferner die Leiterplatine festgehalten und fixiert.

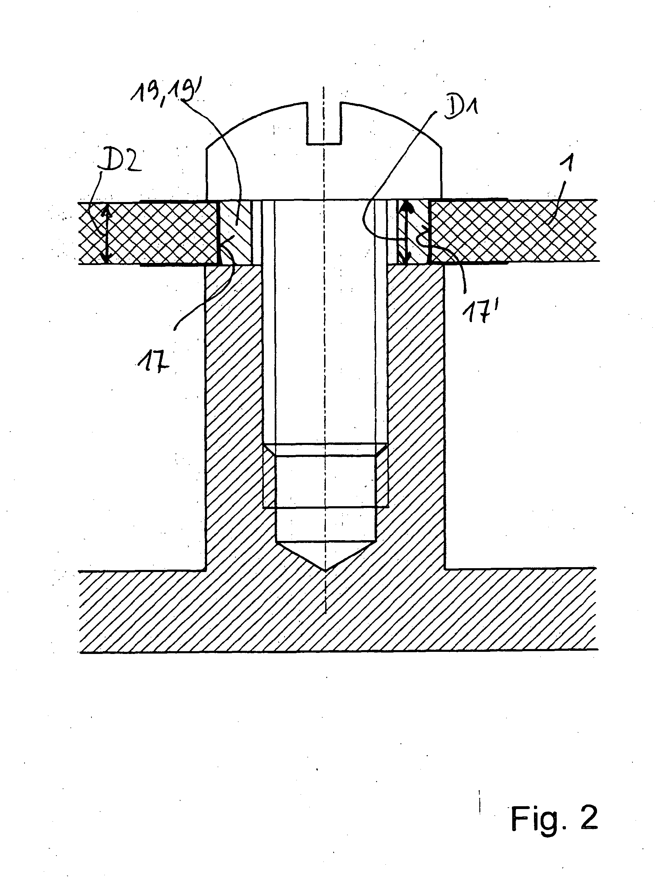

Anhand von Figur 2 wird gezeigt, dass insbesondere dann, wenn die Dicke D1 des Kontaktelementes 19' und die Dicke D2 der Leiterplatine gleich groß sind, es auch möglich ist, die Durchmesserabmessung des Kontaktelementes 19 kleiner zu wählen als die Durchmessergröße der Ausnehmung 17 der Leiterplatine. Dadurch kommt also ein Abschnitt der Leiterplatine benachbart zur Ausnehmung 17 ebenfalls noch zwischen den unter Druck stehenden Anlageflächen zwischen der Unterseite des Schaubenkopfes und der Auflagenfläche 11 des Domes 5 zu liegen. Dies ist in der Regel jedoch unschädlich, da die hohen Verpresskräfte zwischen Schraubenkopf und Dom dauerhaft über die Kontakteinrichtung 19 aufgenommen werden, so dass die hier eventuell noch auftretenden hohen Verpresskräfte benachbart zur Ausnehmung 17 der Leiterplatine 1 nur dazu führen können, dass das Material der Leiterplatine hier geringfügig durch Kriechen versucht auszuweichen, die hohen Verpresskräfte aber durch das aus Metall bestehende Kontaktelement 19 weiterhin aufrecht erhalten werden.

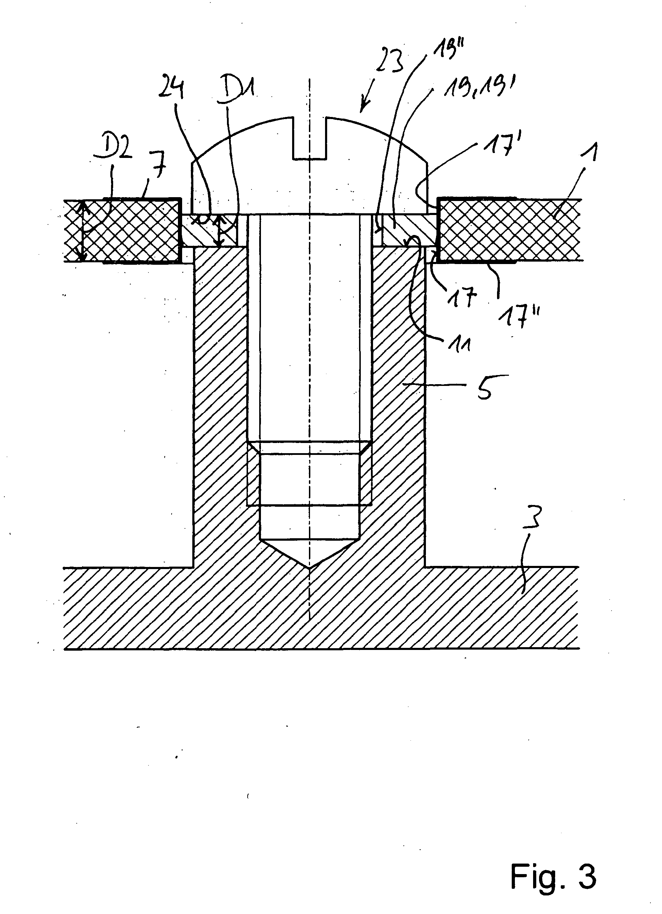

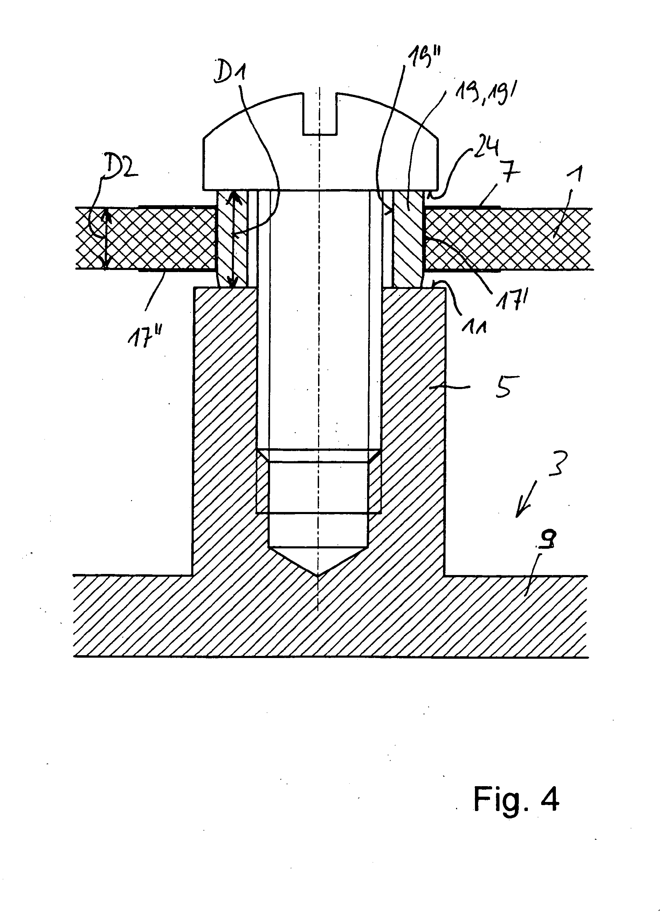

Anhand von Figur 3 und anhand von Figur 4 ist lediglich gezeigt, dass die Dicke D1 in Axialrichtung der Schraube (also in Zentralrichtuizg Z) auch kleiner oder größer als die Dicke D2 der Leiterplatine sein können. Ein Vorteil des Ausführungsbeispieles gemäß Figur 4 besteht darin, dass der Außendurchmesser des Kontaktelementes 19' kleiner als der Durchmesser des Schraubenkopfes 23" sein kann und dadurch mehr Leiterplatinenfläche für die elektrische Schaltung zur Verfügung steht.

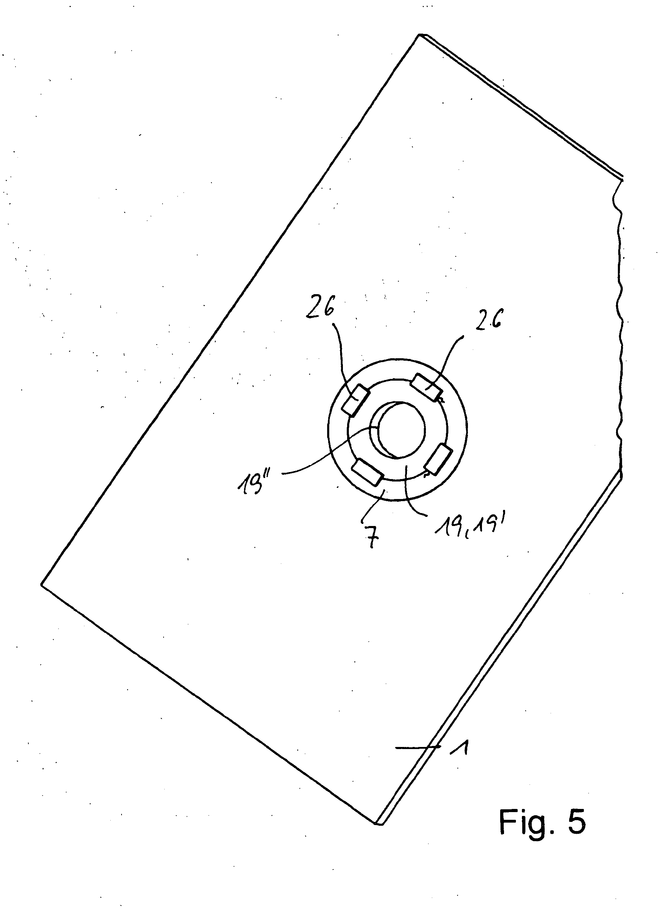

Anhand der schematischen Draufsicht auf die Leiterplatine 1 gemäß Figur 5 ist gezeigt, dass das Kontaktelement 19' beispielsweise auch vor dem Reflow-Löten in die Ausnehmung 17 der Leiterplatine 1 eingepresst werden kann, wobei ein möglicherweise bestehender Spalt zwischen dem Außenumfang der Kontakteinrichtung 19 und der Wandung im Material der Leiterplatine 1, die die Ausnehmung 17 begrenzt, zumindest partiell mit Lötpaste 26 überdruckt sein kann. Diese Lötpasten-Abschnitte 26 sind in Figur 5 in Draufsicht mit den Bezugszeichen 26 versehen. Während des Reflow-Lötens im Reflow-Ofen beginnt die Lötpaste 26 dann zu schmelzen, wodurch eine ausreichend gute Lötverbindung zwischen der Kontakteinrichtung 19 und dem entsprechenden Kontaktabschnitt 7 der Leiterplatine hergestellt wird.

Dabei kann die Lötpaste nur auf der Bauteilseite aufgedruckt werden (in Figur 5 untenliegend, also auf der Seite, auf der beispielsweise elektrische Bauteile und Baukompnenten, SMD-Teile etc. angeordnet sind) und als Alternative kann die Lötpaste auch nur auf der gegenüberliegenden Lötseite aufgedruckt sein, oder sowohl auf der Bauteil- als auch auf der Lötseite, also auf beiden Seiten der Leiterplatine.

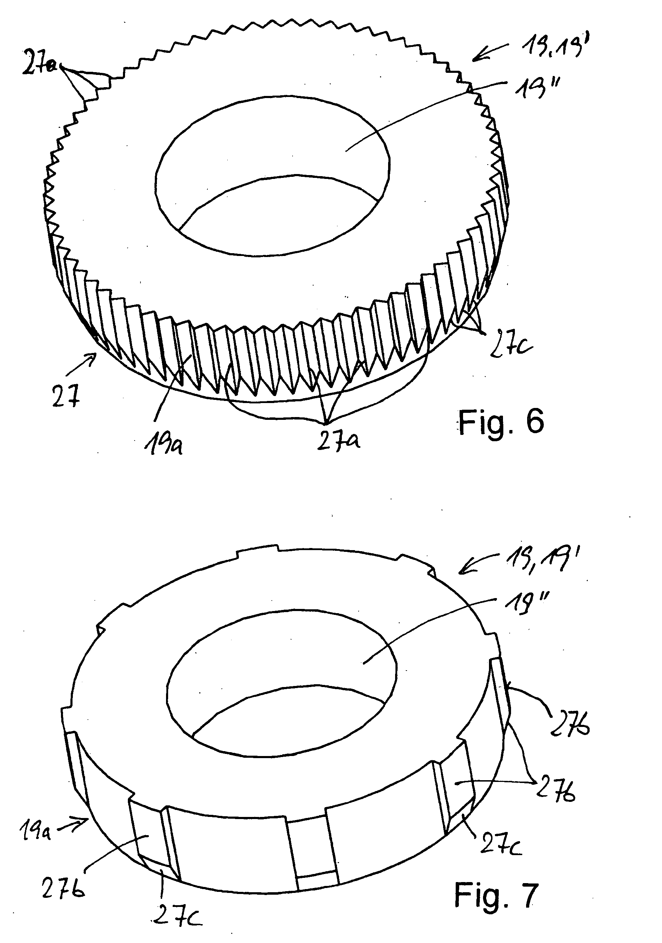

In Figur 6 ist ein Beispiel für die Ausgestaltung des scheibenförmigen Kontaktelementes 19 gezeigt. Es kann bevorzugt rotationssymmetrisch gestaltet sein, beispielsweise in Form eines Drehteiles, welches an seinem Außenumfang 19a mit einer Rändelung 27 versehen ist, die stegförmige Rippen aufweist, die in Axialrichtung Z ausgerichtet sind. Diese Ausführungsform ist besonders zum Verpressen in die Ausnehmung 17 der Leiterplatine 1 geeignet, wobei sich die durch die Rändelung ergebenden rippenförmigen.Erhebungen 27a in das Material der Durchkontaktierung 17 in der Ausnehmung 17 einkerben können. Dadurch wird zum einen eine gute und feste mechanische Verbindung sowie eine optimale elektrisch-galvanische Verbindung zwischen der Durchkontaktierung 17' in der Ausnehmung 17 und der Kontakteinrichtung 19 gewährleistet, wodurch ein fester Sitz der Leiterplatine 1 an der Halteeinrichtung 5 eine elektrische Verbindung zwischen den leitfähigen Kontaktabschnitten 7 auf der Leiterplatine 1 und dem Dom 5 und damit dem Gehäuse gewährleistet.

An allen Erhebungen 27a ist im unteren Bereich eine Fase 27c ausgebildet, um das Einpressen des Kontaktelementes 19 in die Leiterplatine 1 zu erleichtern.

Anhand von Figur 7 ist lediglich gezeigt, dass am Außenumfang 19a der Kontakteinrichtung 19 in Umfangsrichtung versetzt liegende gering dimensionierte mit flachen Außenwandungsabschnitten versehene radial vorstehende Erhebungen 27b vorgesehen sein können, die in Steckrichtung vorlaufend mit keilförmigen Schrägen 27c versehen sind. Auch dadurch lassen sich diese Kontaktelemente optimal in die Ausnehmungen bzw. in die Durchkontaktierungen der Ausnehmungen 17 einpressen.

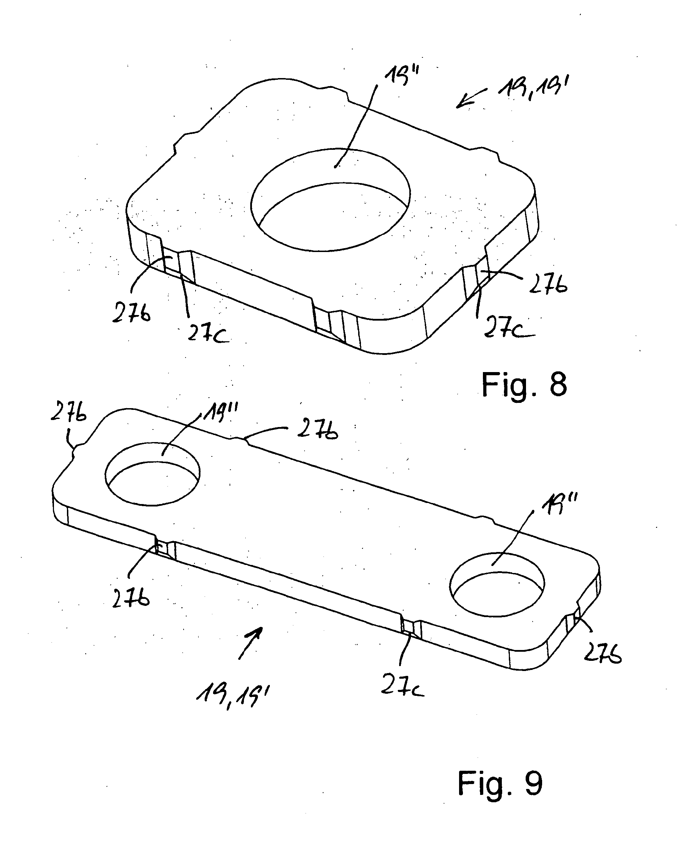

Anhand von Figur 8 wird gezeigt, dass die Kontakteinrichtung 19 vom Grundsatz her nicht zwingend scheibenförmige oder rotationssymmetrisch ausgebildet sein muss. Auch n-polygonale Querschnittsformen kommen in Betracht, beispielsweise ein eher rechteckförmiges Kontaktelement mit abgerundeten Ecken, wie anhand von Figur 8 gezeigt. Dadurch ergibt sich ein insgesamt eher quaderförmiges Kontaktelement 19'. Die Ausnehmung 19" kann dabei gleichwohl kreisförmig gestaltet sein, mit einem Innendurchmesser, der anhand von anderen Ausführungsbeispielen gezeigt ist, in der Regel zumindest geringfügig größer ist als der Außendurchmesser des Schraubenschaftes.

In diesem Ausführungsbeispiel ist nicht der Durchmesser, sondern die Längs- und/oder Quererstreckung des Kontaktelementes 19' so zu wählen, dass es mit der entsprechenden Längs- und Quererstreckung der Ausnehmung 17 in der Leiterplatine korrespondiert.

Für die bisher gezeigten und teilweise auch für die noch kommenden Ausführungsbeispiele ergibt sich immer dann, wenn das Kontaktelement in der Ausnehmung 17 der Leiterplatine fest verpresst ist, eine quasi mechanisch unlösbare und elektrisch sehr gut leitende Verbindung zwischen der Kontakteinrichtung und der Durchkontaktierung bzw. dem elektrisch leitfähigen Kontaktabschnitt 7 auf der Leiterplatine. Dabei kann bei diesem, wie auch bei allen anderen Ausführungsbeispielen angemerkt werden, dass die erwähnte Schraubverbindung keine oder nur sehr geringe Kraft auf die Leiterplatine ausübt, da letztlich nur die Kontakteinrichtung 19 bzw. das Kontaktelement 19' mechanisch belastet wird (mit Ausnahme des Ausführungsbeispieles nach Figur 2, wo noch eine geringfügige Belastung des Materials der Leiterplatine gegeben ist). Durch die Schraubverbindung sind die Verbindungseinrichtungen stets lösbar und beliebig wieder herstellbar.

Figur 9 zeigt, dass die Kontakteinrichtung 9 auch in unterschiedlichen Längs- und/oder Querbemaßungen vorgesehen sein kann, wobei hier sogar mehrere Ausnehmungen 17 vorgesehen sein können, wenn beispielsweise zwei Schrauben mit dieser Kontakteinrichtung zusammenwirken sollen. In diesem Falle würden zwei Dome 5 unterhalb der Ausnehmungen 17 angeordnet sein. In diesem wie in den vorausgegangenen Beispielen sind am Außenumfang 19a wiederum entsprechende flache Außenwanderhebungen 19b mit Schrägen 27c vorgesehen, die in die Durchkontaktierungen der entsprechenden Öffnung der Leiterplatine eingepresst werden. Dabei versteht sich von selbst, dass die Ausnehmung 17 der Leiterplatine jeweils an die entsprechende Formgebung der Kontakteinrichtung angepasst ist, zumindest was die Lage und Anordnung der vom Außenumfang überstehenden Erhebungen 27b betrifft, die sich mit der die Ausnehmung 17 in der Leiterplatine 1 begrenzenden Innenwandung bzw. der dort ausgebildeten Durchkontaktierung mechanisch und elektrisch wechselwirken sollen, um den erwähnten Presssitz zu gewährleisten.

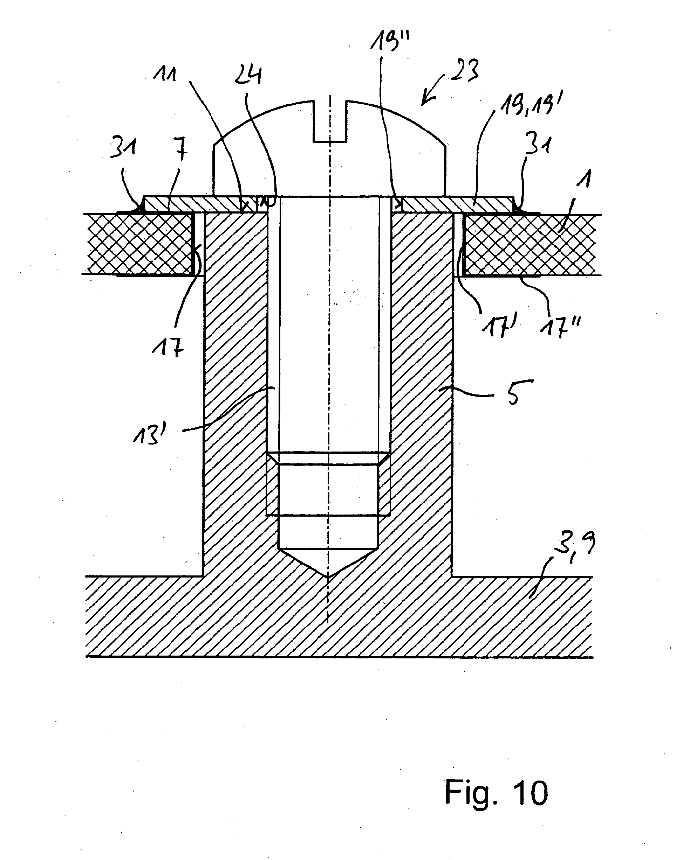

Figur 10 zeigt, dass die Kontakteinrichtung nicht zwingend in der Ausnehmung 17 in einer dort vorgesehenen Durchkontaktierung verpresst sein muss. Die Querschnittsdarstellung gemäß Figur 10 zeigt, dass die Kontakteinrichtung beispielsweise in Form eines SMD-Bauteil wie beim SMD-Bestücken auf der Leiterplatine 1 platziert und beim Reflow-Löten wie alle anderen elektrischen Bauteile auch mit der Leiterplatine verlötet werden kann. In diesem Falle ist die Außenabmessung der Kontakteinrichtung 19 größer als die Ausnehmung 17 in der Leiterplatine 1. Durch die Verlötung (in Figur 10 ist das Lot 31 ersichtlich) ist das elektrisch leitfähige aus Metall bestehende Kontaktelemet 19 mit einem darunter befindlichen Kontaktabschnitt 7 auf der Leiterplatine 1 elektrisch-galvanisch verbunden und darüber auch mechanisch an der Leiterplatine fixiert. Die Ausnehmung 17 der Leiterplatine 1 ist so groß bemessen, dass der domförmige Halteabschnitt 5 in die Ausnehmung 17 eingreifen und diese durchsetzen kann, so dass das scheibenförmige Kontaktelement 19 zwischen der Unterseite des Schraubenkopfes 23" und der auf der Oberseite des Halteabschnittes 5 ausgebildeten Auflagefläche 11 sandwichartig verpresst ist, nämlich durch das entsprechend feste Eindrehen der Schraube 23 in das Innengewinde 13' der Innenbohrung 13 in dem domförmigen Halteabschnitt 5.

Auch in diesem Ausführungsbeispiel wird die Leiterplatine 1 mechanisch nicht oder nur in ganz geringem Maße belastet. Ein Vorteil dieser Variante ist, dass der Aufbau auch zur Masseanbindung von einseitigen Leiterplatinen verwendet werden kann, bei denen Durchkontaktierungen nicht möglich sind.

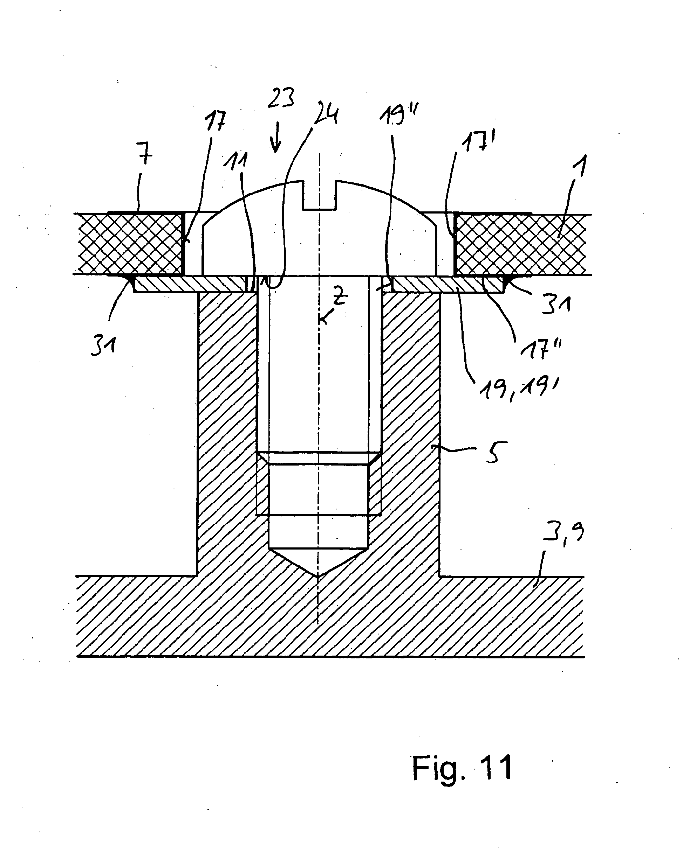

Figur 11 zeigt eine Abwandlung zu Figur 10 in der Gestalt, dass hier das scheibenförmige Kontaktelement die Ausnehmung 17 übergreifend auf der Unterseite der Leiterplatine 1 verlötet ist. Hier ist ebenfalls eine Durchkontaktierung 17' in der Ausnehmung 17 vorgesehen, so dass hier eine elektrisch leitfähige Verbindung von dem domförmigen Halteabschnitt 5, dem Kontaktelement 19', der Verlötung auf der Unterseite der Leiterplatine und über die Durchkontaktierung 17' zu der auf der Oberseite der Leiterplatine ausgebildeten Kontaktstelle 7 hergestellt ist. In diesem Falle ist der Durchmesser der Ausnehmung 17 der Leiterplatine größer als der Außendurchmesser des Schraubenkopfes 23", so dass der Schraubenkopf 23" die Ausnehmung 17 in der Leiterplatine durchragt bzw. darin eintaucht.

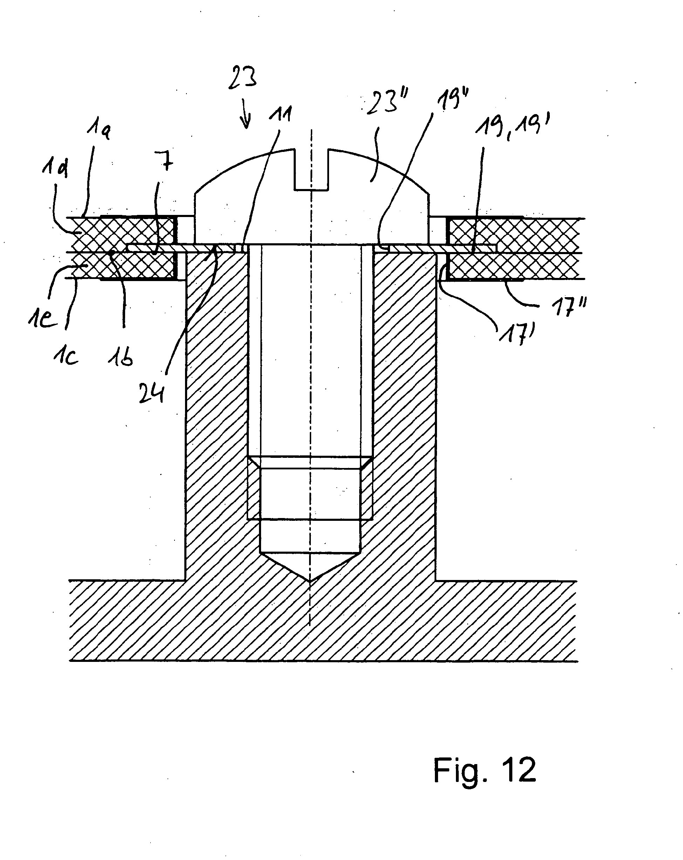

Anhand von Figur 12 ist eine Leiterplatine gezeigt, die als Multilayer z.B. mit drei leitenden Ebenen 1a, 1b und 1c sowie zwei Isolierschichten 1d und 1e ausgebildet ist. Die Leiterplatine 1 gemäß Figur 12 weist also auch im Inneren eine elektrisch leitende Ebene auf, die auch als leitfähiger Kontaktabschnitt 7 bezeichnet werden kann. Das scheibenförmige Kontaktelement 19' ist während der Leiterplatinenherstellung auf die innere elektrisch leitende Ebene 1b, 7 der Leiterplatine 1, 7 platziert und elektrisch leitend mit dieser Innenlage 1b verbunden worden. In diesem Ausführungsbeispiel ragt sowohl der Schraubenkopf 23" von oben her als auch der Gehäusedom (Halteabschnitt 5) von unter her in einer Teilhöhe in die Ausnehmung-17 in der Leiterplatine 1, so dass durch Eindrehen der Schraube 23 der entsprechende Abschnitt der scheibenförmigen Kontakteinrichtung 19 zwischen Schraubenkopf 23" und der Auflagefläche 11 des Gehäusedoms 5 mit ausreichend hoher Klemmwirkung verschraubt sein kann.

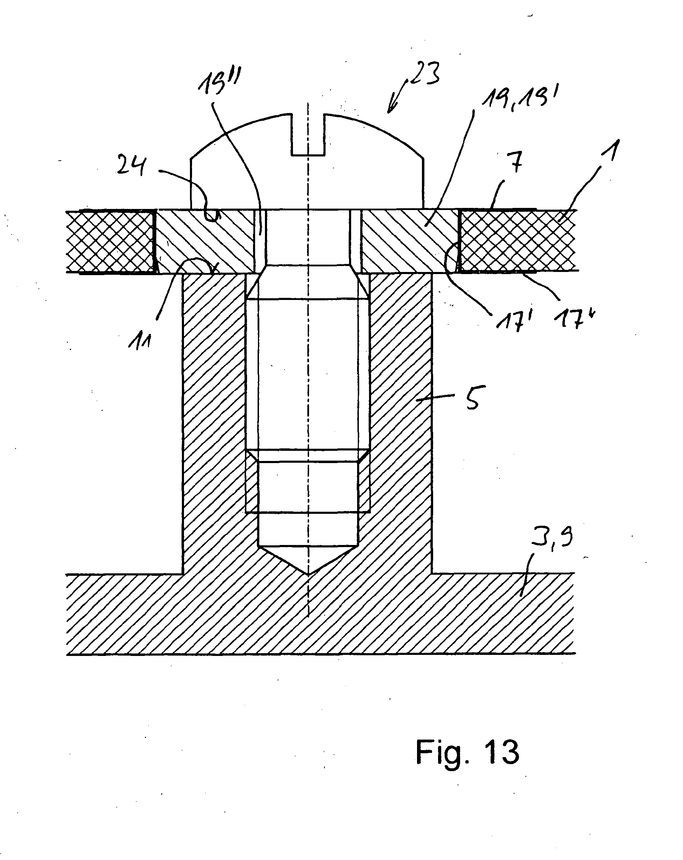

Das Ausführungsbeispiel gemäß Figur 13 zeigt schließlich eine Variante, bei welcher das Kontaktelement 19 unverlierbar mit der Schraube verbunden ist (wie im Falle einer Kombi-Schraube). Das scheibenförmige Kontaktelement 19' ist dabei wiederum rotationssymmetrisch wie bei dem Ausführungsbeispiel nach Figur 6 und 7 gezeigt gestaltet. Das Kontaktelement 19' wird beim Eindrehen der Schraube in die Leiterplatine 1 eingepresst. Mit anderen Worten wird bei zunehmenden Eindrehen des Schraubenschaftes 23' in das Innengewinde 13' der Innenbohrung 13 des Haltedomes 5 über den Schraubenkopf die scheibenförmige Kontakteinrichtung 19 in die mit der Durchkontaktierung versehenen Ausnehmung 17 eingepresst. Die Unverlierbarkeit des Kontaktelementes wird dadurch gewährleistet, dass der Schraubenschaft nach einem an den Schraubenkopf angrenzenden verjüngten Durchmesserabschnitt in einen anschließenden Schaftabschnitt übergeht, dessen Durchmesser größer ist als der Innendurchmesser der lochförmigen Ausnehmung 19" in dem Kontaktelement 19'.

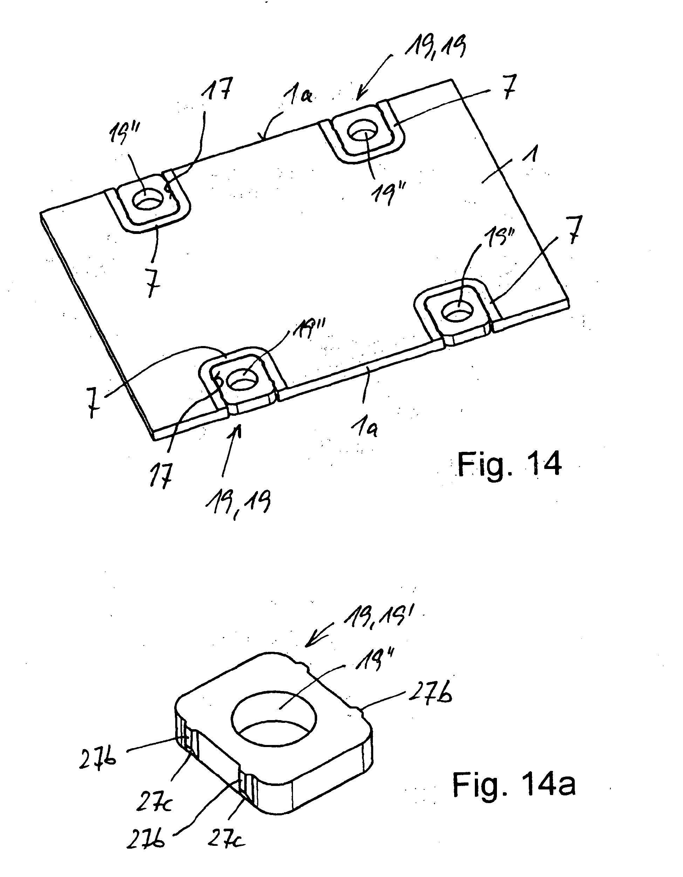

Nachfolgend wird ein abgewandeltes Ausführungsbeispiel anhand von Figur 14 und 14a erläutert. Die Ausführungsvariante gemäß Figur 14 unterscheidet sich von dem Ausführungsbeispiel gemäß Figur 1 und 1a dadurch, dass beispielsweise die Ausnehmungen 17 für die Kontakteinrichtungen 19, d.h. die Kontaktelemente 19', nicht als von dem Leiterplatinenmaterial völlig umschlossene Löcher oder Bohrungen gestaltet sind, sondern als Ausnehmungen, die zu dem Rand 1a der Leiterplatine hin offen sind. Im gezeigten Ausführungsbeispiel sind beispielsweise die Ausnehmungen 17 in der Leiterplatine 1 als in das Leiterplatinenmaterial U-förmig eingreifende Ausnehmungen gestaltet. Diese Ausnehmungen müssen aber nicht U-förmig, also rechteckförmig oder quadratisch gestaltet sein, sondern können beliebige Formen aufweisen, auch rund gestaltet sein etc. In diesem Fall sollte nur ein rundes Kontaktelement vom Leiterplatinenmaterial mit mehr als 180° Umfangsbegrenzung umgeben sein, damit ein entsprechendes Kontaktelement sicher in der Ausnehmung 17 gehalten ist. Bei der Variante gemäß Figur 14 weisen die Kontaktelemente 19' dabei ebenfalls die Ausnehmung oder Bohrung 19" auf, durch die hindurch der Schraubenschaft 23' einer Schraube 23 zur Befestigung der Leiterplatine hindurch-gesteckt und in eine entsprechende Innenbohrung 13 befestigt werden kann.

Bei der Einzeldarstellung der Kontakteinrichtung 19 gemäß Figur 14a ist zu ersehen, dass das Kontaktelement ebenfalls, wie bereits anhand anderer Ausführungsbeispiele erläutert, mit einer Rändelung oder mit flachen, rippenförmigen Erhebungen 27b mit einer nach unten weisenden Abschrägung oder Fase 27c versehen sind, wodurch das Einstecken des Kontaktelements in die Ausnehmung 17 erleichtert wird.

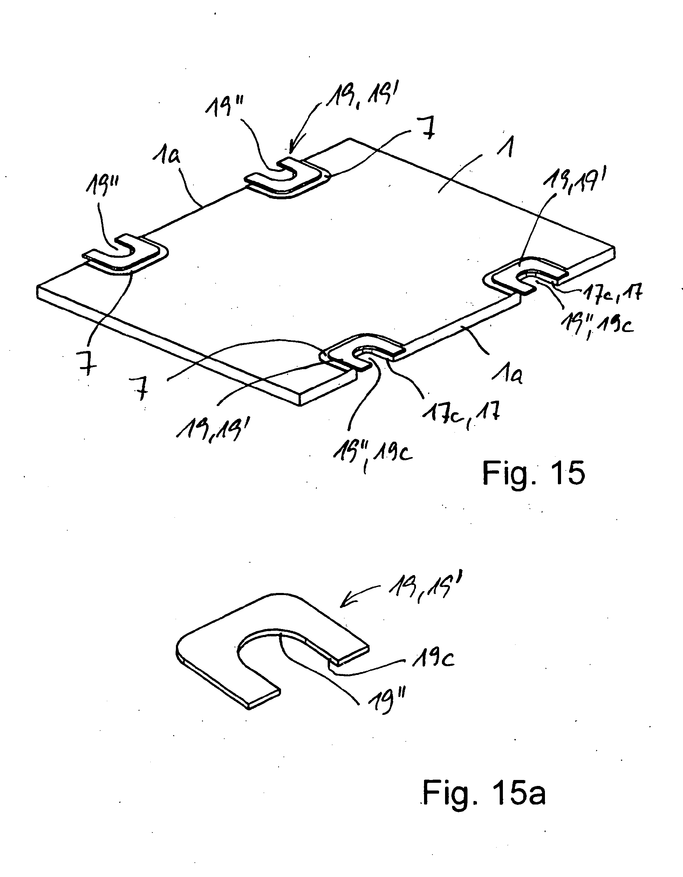

Bei der Variante gemäß Figur 15 und 15a ist das betreffende Kontaktelement 19' nicht als geschlossenes Kontaktelement ausgebildet, welches die darin befindliche Ausnehmung oder Bohrung 19" in vollem Umfange umgibt, sondern in sich ebenfalls U-förmig. Somit weist auch das Kontaktelement 19" einen Öffnungsabschnitt 19c auf, der in der gleichen Richtung wie der Öffnungsabschnitt 17c im Leiterplatinenmaterial liegt. Durch diese Öffnung hindurch wird wiederum der Schraubenschaft im entsprechenden Fixierabschnitt in der Regel im Dom 5 eingedreht.

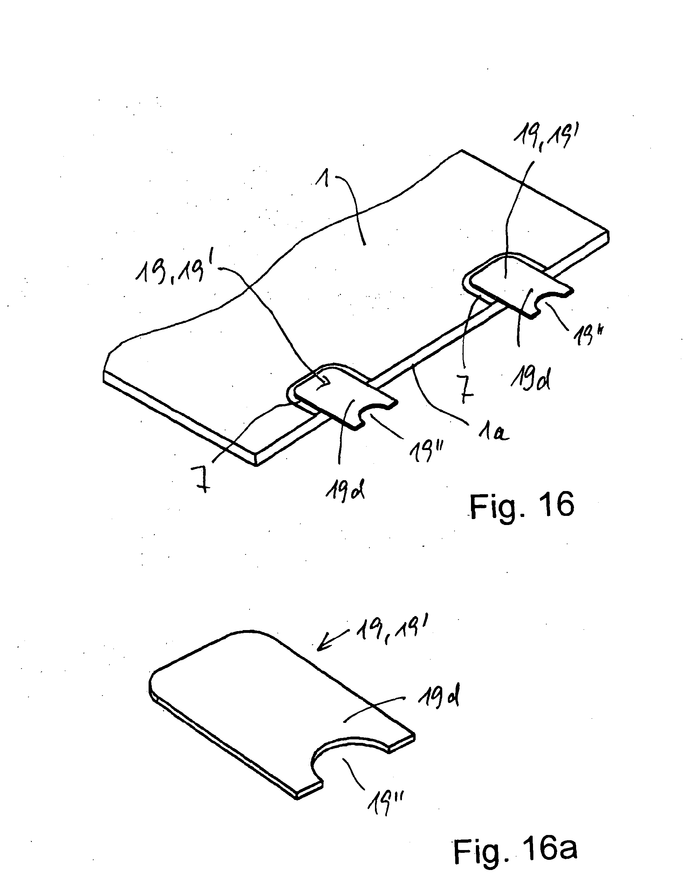

Anhand von Figur 16 und Figur 16a wird nur schematisch ein abschließendes Ausführungsbeispiel gezeigt, dass die Leiterplatine selbst überhaupt keine Ausnehmungen 17 aufweisen muss, sondern dass es ausreichend sein kann, entsprechende Kontakteinrichtungen 19 an entsprechenden Kontaktstellen 7 auf der Leiterplatine 1 aufzulöten, wobei die Kontakteinrichtung 19 mit einem entsprechenden Kontakteinrichtungs-Abschnitt 19d versehen ist, der beispielsweise mit einer von dem Kontakteinrichtungs-Abschnitt 19d voll umgebenden Bohrung oder Ausnehmung 19" oder mit einer U-förmigen, nach außen hin zumindest einseitig offenen Ausnehmung 19" versehen ist oder versehen sein kann, durch die der Schraubenschaft hindurchtritt bzw. teilweise eingreift. Es wäre sogar denkbar, dass der Kontakteinrichtungs-Abschnitt 19d nur eine leichte, konkave Ausnehmung 19", wie in Figur 16 gezeigt, aufweist oder sogar nur gerade verlaufend gestaltet ist, was immer noch erlauben würde, dass zwischen einem Abschnitt der Unterseite des Schraubenkopfes oder dem sogenannten Fixieranschlag 24 und der Oberseite 11 des Domes 5 sandwichartig ein derartiger Randabschnitt des Kontakteinrichtungs-Abschnittes 19d zu liegen kommt, der dadurch ebenfalls verklemmt werden kann. Auch dadurch kann letztlich die Leiterplatine gehalten werden, wenn mehrere derartige über den Rand 1a der Leiterplatine 1 überstehende, elektrischleitfähige Kontakteinrichtungen 19 bzw. Kontaktelemente 19' verwendet werden.

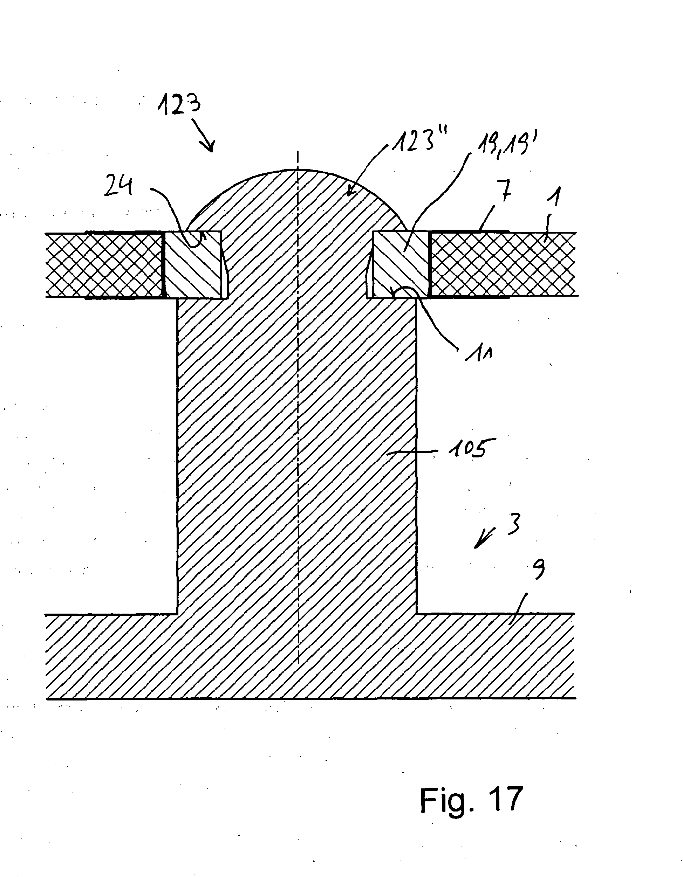

Abschließend wird unter Bezugnahme auf Figur 17 ein abgewandeltes Ausführungsbeispiel gezeigt, bei welchem anstelle einer Befestigung mittels einer Schraube ein Nietzapfen verwendet wird.

Der Nietzapfen 123 umfasst hierbei den eigentlichen domähnlichen Halteabschnitt 105 mit einer auf der Oberseite zur Auflage der Leiterplatine dienenden Auflagefläche 11, wobei der eigentliche Nietkopf 123" über den Halteabschnitt 105 mit geringerem Durchmesser übersteht. Der Durchmesser ist während des Herstellungsprozesses kleiner als die Durchtrittsöffnung der Kontakteinrichtung 19 bzw. des Kontaktelementes 19'. Im Falle der Ausführungsformen gemäß den Figuren 15 bis 16a könnte der "Hals" 125 entsprechend schmal und der Nietkopf 123"-schon mit größerer Quererstreckung ausgebildet sein, wenn die Möglichkeit besteht; die zur Seite hin offenen Kontakteinrichtungen 19, 19' entsprechend dem Ausführungsbeispiel nach Figur 15 oder 16 auf den Hals des Nietzapfens 23 aufzuschieben. Während des Nietvorganges wird dann der entsprechende Nietkopf 123" mit größerer Radialerstreckung ausgebildet und übergreift die Kontakteinrichtung 19, d.h. das Kontaktelement 19', wodurch die Leiterplatine fixiert und elektrisch kontaktiert ist.

Bei Verwendung von Nietzapfen ist also ersichtlich, dass der domähnliche Halteabschnitt 105 Teil des Nietzapfens ist, wobei der gesamte Nietzapfen 123 mit dem Nietkopf 123" und dem Halteabschnitt 105 bevorzugt Teil des Bodens 9 und/oder des Gehäuses 3 ist, wobei der die Leiterplatine über das Kontaktelement haltende Nietkopf 123" durch Kraftbeaufschlagung und Materialverformung gebildet wird.

Im Rahmen der Ausführungsbeispiele ist also erläutert worden, dass eine Variante die Kontakteinrichtung 19 in einer Ausnehmung 17 in der Leiterplatine eingepresst sein kann, wobei zur Realisierung der elektrisch leitenden Verbindung zwischen der Kontakteinrichtung 19 und der Leiterplatine 1 die Ausnehmung 17 durchkontaktiert ist oder die Kontakteinrichtung 19 und Leiterplatine 1 zusätzlich verlötet sein können. Die verwendete Kontakteinrichtung 19 ist dabei im Rahmen der Erfindung auf einfachste Weise herstellbar. Dies ergibt sich insbesondere durch die verwendete Formgebung für diese Kontakteinrichtung 19. Denn die Kontakteinrichtung 19 weist bevorzugt eine ebene Grundform ohne zusätzliche Formelemente wie einen Bund, einen Flansch, einen sich davon erhebenden Zylinder etc. auf. Dies ermöglicht, dass die erfindungsgemäße Kontakteinrichtung beispielsweise durch Stanzen und/oder Prägen herstellbar ist, ohne dass nachfolgende Biegeoperationen oder weitere Bearbeitungsschritte erforderlich oder gar notwendig wären.

## Patentansprüche

1. Elektrische Verbindungseinrichtung zur Anbringung einer Leiterplatine (1) an zumindest einem, vorzugsweise Teil eines elektrisch leitfähigen Gehäuses (3) bildenden Leiterplatinen-Halteabschnittes (5, 105), mit folgenden Merkmalen:
- eine elektrisch leitfähige Kontakteinrichtung (19),
- die elektrisch leitfähige Kontakteinrichtung (19) ist mit einem elektrisch leitfähigen Kontaktabschnitt (7) auf der Leiterplatine (1) elektrisch und mechanisch fest verbunden,
- ein Leiterplatinen-Halteabschnitt (5, 105) mit einer elektrisch leitfähigen Auflagefläche (11),
- zumindest ein Abschnitt der Kontakteinrichtung (19) ist zwischen einem einen Schraubenschaft (23') oder einen Nietzapfen (123) radial überragenden Fixieranschlag (24) und der Auflagefläche (11) an dem Halteabschnitt (5, 105) unter Erzeugung einer auf das Kontaktelement (19) wirkenden Klemmkraft mechanisch fixiert und elektrisch kontaktiert, wobei die eingeleiteten Klemmkräfte nicht oder nicht maßgeblich auf das Material der Leiterplatine (1) selbst einwirken,
- die Kontakteinrichtung (19) besteht aus einem Material, dessen zulässige Flächenpressung über der zulässigen Flächenpressung des Leiterplatinen-Materials liegt, und
- die zulässige Flächenpressung für die Kontakteinrichtung (19) liegt mehr als 20% über der zulässigen maximalen Flächenpressung für das Leiterplatinen-Material.

2. Verbindungseinrichtung nach Anspruch 1, **dadurch gekennzeichnet, dass** die Kontakteinrichtung (19) in eine mit einer Durchkontaktierung (17') versehenen Ausnehmung (17) eingepresst oder in eine mit Lot gefüllten Ausnehmung (17) verlötet ist.

3. Verbindungseinrichtung nach Anspruch 1, **dadurch gekennzeichnet, dass** die scheibenförmig ausgebildete Kontakteinrichtung (19) eine Außenabmessung aufweist, die größer ist als die Ausnehmung (17) in der Leiterplatine (1) oder dass die Kontakteinrichtung (19) so ausgebildet ist, dass sie über den Rand (1a) der Leiterplatine (1) nach außen hin übersteht, wobei die scheibenförmige Kontakteinrichtung (19) auf der Ober- oder auf der Unterseite oder auf einer innenliegenden elektrisch leitenden Schicht (1b) einer Leiterplatine (1) mit einer Mehr-Layer-Struktur elektrisch-galvanisch verbunden und darüber auch mechanisch an der Leiterplatine (1) fixiert ist.

4. Verbindungseinrichtung nach einem der Ansprüche 1 bis 3, **dadurch gekennzeichnet, dass** die zulässige Flächenpressung für die Kontakteinrichtung (19) mehr als 20 %, insbesondere mehr als 40 %, mehr als 60 %, mehr als 80 % oder mehr als 100 % über der zulässigen maximalen Flächenpressung für das Leiterplatinen-Material liegt.

5. Verbindungseinrichtung nach Anspruch 4, **dadurch gekennzeichnet, dass** die zulässige Flächenpressung (p_{zul}) des Materials der Kontakteinrichtung (19) über 100 N/mm² vorzugsweise über 120, über 140, über 160, über 180 und insbesondere über 2.00 N/mm² liegt, vorzugsweise zwischen 200 N/mm² bis 600 N/mm².

6. Verbindungseinrichtung nach einem der Ansprüche 1 bis 5, **dadurch gekennzeichnet, dass** neben dem Halteabschnitt (5, 105) und der Schraube (23) bzw. dem Nietzapfen (123) auch die Kontakteinrichtung (19) aus Metall, insbesondere einer Metalllegierung und insbesondere aus Stahl besteht.

7. Verbindungseinrichtung nach einem der Ansprüche 1 bis 6, **dadurch gekennzeichnet, dass** die durch die Schraube (23) oder den Nietzapfen (123) erzeugten Vorspannkräfte mit weniger als 50 %, insbesondere weniger als 40 %, 30 %, 20 % und insbesondere weniger als 10 % auf die Leiterplatine (1a) wirken.

8. Verbindungseinrichtung nach einem der Ansprüche 1 bis 5, **dadurch gekennzeichnet, dass** die Kontakteinrichtung (19) scheibenförmig gestaltet ist.

9. Verbindungseinrichtung nach einem der Ansprüche 1 bis 8, **dadurch gekennzeichnet, dass** die Kontakteinrichtung (19) mit einer Ausnehmung (19") versehen ist, die von dem Schraubenschaft (23') durchsetzt ist.

10. Verbindungseinrichtung nach Anspruch 9, **dadurch gekennzeichnet, dass** der Außendurchmesser der elektrisch leitfähigen Kontakteinrichtung (19) zumindest teilweise geringfügig größer ist als der entsprechende Innendurchmesser der mit der Durchkontaktierung (17') versehenen Ausnehmung.

11. Verbindungseinrichtung nach Anspruch 9, **dadurch gekennzeichnet, dass** am Außenumfang (19a) der Kontakteinrichtung (19) eine Rändelung (27) oder rippenförmige Erhebungen (27a) oder abschnittsweise versetzt zueinander liegende flache Erhebungen (27b) vorzugsweise mit in Einsteckrichtung keilförmig vorlaufende Schrägen (27c) ausgebildet sind.

12. Verbindungseinrichtung nach einem der Ansprüche 1 bis 10, **dadurch gekennzeichnet, dass** der Durchmesser oder die Längs- oder Quererstreckung der Kontaktiereinrichtung (19) gleich oder kleiner ist als der Durchmesser oder die Längs- oder die Quererstreckung des benachbart zur Leiterplatine ausgebildeten Halteabschnittes (5, 105) und/oder gleich oder kleiner ist als der Durchmesser des Schraubenkopfes (23") bzw. gleich oder kleiner ist als der mit dem Schraubenschaft (23') verbundene Fixieranschlag (24).

13. Verbindungseinrichtung nach einem der Ansprüche 1 bis 10, **dadurch gekennzeichnet, dass** der Durchmesser oder die Längs- oder Quererstreckung der Kontakteinrichtung (19) größer ist als der Durchmesser oder die Längs- oder die Quererstreckung des benachbart zur Leiterplatine ausgebildeten Halteabschnittes (5, 105) und/oder größer ist als der Durchmesser des Schraubenkopfes (23") bzw. größer ist als der mit dem Schraubenschaft (23') verbundene Fixieranschlag (24).

14. Verbindungseinrichtung nach einem der Ansprüche 1 bis 10, **dadurch gekennzeichnet, dass** die Kontakteinrichtung (19) eine Dicke (D1) aufweist, die der Dicke (D2) der Leiterplatine (1) entspricht oder weniger als 2 %, insbesondere weniger als 1 % oder 0,5 % davon abweicht.

15. Verbindungseinrichtung nach einem der Ansprüche 1 bis 13, **dadurch gekennzeichnet, dass** die Dicke (D1) der Kontakteinrichtung (19) größer ist als die Dicke (D2) der Leiterplatine, wobei die Kontakteinrichtung (19) an zumindest einer Seite der Leiterplatine und vorzugsweise an beiden gegenüberliegenden Seiten der Leiterplatine (1) über die jeweilige Leiterplatinen-Oberfläche übersteht.

16. Verbindungseinrichtung nach einem der Ansprüche 1 bis 13, **dadurch gekennzeichnet, dass** die Dicke (D1) der Kontakteinrichtung (19) kleiner ist als die Dicke (D2) der Leiterplatine (1), und dass die Kontakteinrichtung (19) innerhalb der Ausnehmung (17) mit der Leiterplatine (1) in dieser Ausnehmung (17) verpresst und/oder verlötet ist, wobei der Durchmesser bzw. die Längs- und oder Quererstreckung der Kontakteinrichtung (19) größer ist als der Durchmesser des Schraubenkopfes (23")und/oder der an dem Schraubenschaft (23') oder dem Nietzapfen (123) ausgebildeten Fixieranschlages (24) und größer ist als der Durchmesser bzw. die Längs- und oder Quererstreckung des benachbarten Bereiches des Halteabschnittes (5, 105).

17. Verbindungseinrichtung nach einem der Ansprüche 1 bis 8, **dadurch gekennzeichnet, dass** die Kontakteinrichtung (19) dünner als die Leiterplatine (1) ist, und dass der in die Ausnehmung (17) eingreifende Schraubenkopf (23") bzw. der in die Ausnehmung (17) eingreifende Fixieranschlag (24) und/oder der in die Ausnehmung (17) eingreifende benachbarte Bereich des Halteabschnittes (5, 105) einen Außendurchmesser und/oder eine Außenkontur aufweist, die zumindest teilweise in die Ausnehmung (17) eintaucht.

18. Verbindungseinrichtung nach einem der Ansprüche 1 bis 17, **dadurch gekennzeichnet, dass** die Ausnehmung (17) zur Aufnahme der Kontakteinrichtung (19) oder des Kontaktelementes (19') umlaufend vom Material der Leiterplatine (1) umgeben ist.

19. Verbindungseinrichtung nach einem der Ansprüche 1 bis 17, **dadurch gekennzeichnet, dass** die Ausnehmung (17) im Randbereich (1a) der Leiterplatine (1) vorgesehen ist, wobei die Ausnehmung (17) nur in einem Teilumfangsbereich vom Material der Leiterplatine (1) umgeben und zu einer Seite (1a) zu der Leiterplatine (1) hin offen ist.

20. Verbindungseinrichtung nach einem der Ansprüche 1 bis 17, **dadurch gekennzeichnet, dass** die Kontakteinrichtung (19) oder das Kontaktelement (19') mit einem elektrisch leitfähigen Kontaktabschnitt (7) auf der Leiterplatine (1) direkt elektrisch verbunden ist und über den Rand (1a) der Leiterplatine (1) nach außen übersteht, wobei ein über den Rand (1a) der Leiterplatine (1) überstehender Kontakteinrichtungs-Abschnitt (19d) zwischen dem an dem Schraubenschaft (23') radial überragenden Fixieranschlag (24) und der Auflagefläche (11) an dem Halteabschnitt (5, 105) mechanisch fixiert und elektrisch kontaktiert ist.

21. Verbindungseinrichtung nach Anspruch 19 oder 20, **dadurch gekennzeichnet, dass** die Ausnehmung (19") vollständig vom Material der Kontakteinrichtung (19) bzw. des Kontaktelementes (19') umgeben oder U-förmig oder U-ähnlich oder mit konkaver Formgebung zu einer Seite hin offen gestaltet ist.

22. Verbindungseinrichtung nach einem der Ansprüche 1 bis 21, **dadurch gekennzeichnet, dass** der radial über den Schraubenschaft (23') überstehende Fixieranschlag (24) an der Schraube (23) durch die Unterseite des Schraubenkopfes (23") gebildet ist.

23. Verbindungseinrichtung nach einem der Ansprüche 1 bis 22, **dadurch gekennzeichnet, dass** die Verbindungseinrichtung lösbar ist und dazu die Schraube (23) in eine Bohrung oder Gewindebohrung (13) in den vorzugsweise zum Gehäuse (3) gehörenden Halteabschnitt (5) ein- und ausdrehbar ist.

24. Verbindungseinrichtung nach einem der Ansprüche 1 bis 21, **dadurch gekennzeichnet, dass** der radial über den Nietzapfen (123) überstehende Fixieranschlag (24) an dem Nietzapfen (123) durch die Unterseite des Nietkopfes (123") gebildet ist.

## Claims

1. Electrical connection means for attaching a printed circuit board (1) to at least one printed circuit board holding portion (5, 105), which is preferably part of an electrically conductive housing (3), comprising the following features:
- an electrically conductive contact means (19),
- the electrically conductive contact means (19) is electrically and mechanically rigidly connected to an electrically conductive contact portion (7) on the printed circuit board (1)
- a printed circuit board holding portion (5, 105) comprising an electrically conductive contact face (11),
- at least a portion of the contact means (19) is mechanically fixed and electrically contacted between a fixing stop (24), which projects radially over the screw shaft (23') or a rivet pin (123), and the contact face (11) on the holding portion (5, 105), so as to produce a gripping force which acts on the contact element (19), the gripping forces which are introduced having no effect or no significant effect on the material of the printed circuit board (1) itself,
- the contact means (19) consists of a material for which the admissible contact pressure is greater than the admissible contact pressure for the printed circuit board material, and
- the admissible contact pressure for the contact means (19) is more than 20 % greater than the admissible maximum contact pressure for the printed circuit board material.

2. Connection means according to claim 1, **characterised in that** the contact means (19) is pressed into a recess (17) provided with a through-connection (17') or soldered into a recess (17) filled with solder.

3. Connection means according to claim 1, **characterised in that** the contact means (19), which is formed in a disc shape, is of an external size greater than the recess (17) in the printed circuit board (1), or **in that** the contact means (19) is formed in such a way that it projects outwards over the edge (1a) of the printed circuit board (1), the disc-shaped contact means (19) being electrogalvanically connected, on the upper side or underside or on an internal electrical conductive layer (1b) of a printed circuit board (1), to a multi-layer structure, and thereby also being mechanically fixed to the printed circuit board (1).

4. Connection means according to any one of claims 1 to 3, **characterised in that** the admissible contact pressure for the contact means (19) is more than 20 %, in particular more than 40 %, more than 60 %, more than 80 % or more than 100 %, greater than the maximum admissible contact pressure for the printed circuit board material.

5. Connection means according to claim 4, **characterised in that** the admissible contact pressure (p_{zul}) of the material of the contact means (19) is greater than 100 N/mm², preferably greater than 120, greater than 140, greater than 160, greater than 180 and in particular greater than 200 N/mm², preferably between 200 N/mm² and 600 N/mm².

6. Connection means according to any one of claims 1 to 5, **characterised in that**, as well as the holding portion (5, 105) and the screw (23) or rivet pin (123), the contact means (19) also consists of metal, in particular of a metal alloy and in particular of steel.

7. Connection means according to any one of claims 1 to 6, **characterised in that** less than 50 %, in particular less than 40 %, 30 %, 20 % and in particular less than 10 %, of the biasing forces produced by the screw (23) or the rivet pin (123) act on the printed circuit board (1a).

8. Connection means according to any one of claims 1 to 5, **characterised in that** the contact means (19) is disc-shaped in form.

9. Connection means according to any one of claims 1 to 8, **characterised in that** the contact means (19) is provided with a recess (19") which is penetrated by the screw shaft (23').

10. Connection means according to claim 9, **characterised in that** the external diameter of the electrically conductive contact means (19) is slightly greater, at least in part, than the corresponding internal diameter of the recess provided with the through-connection (17').

11. Connection means according to claim 9, **characterised in that** a rim (27) or rib-like elevations (27a) or planar elevations (27b) positioned mutually offset in portions, preferably having slants (27c) which proceed in a wedge shape in the insertion direction, are formed on the outer periphery (19a) of the contact means (19).

12. Connection means according to any one of claims 1 to 10, **characterised in that** the diameter or the longitudinal or transverse extent of the contact means (19) is less than or equal to the diameter or the longitudinal or transverse extent of the holding portion (5, 105) which is formed adjacent to the printed circuit board and/or less than or equal to the diameter of the screw head (23") or less than or equal to the fixing stop (24) connected to the screw shaft (23').

13. Connection means according to any one of claims 1 to 10, **characterised in that** the diameter or the longitudinal or transverse extent of the contact means (19) is greater than the diameter or the longitudinal or transverse extent of the holding portion (5, 105) which is formed adjacent to the printed circuit board and/or greater than the diameter of the screw head (23") or greater than the fixing stop (24) connected to the screw shaft (23').

14. Connection means according to any one of claims 1 to 10, **characterised in that** the contact means (19) is of a thickness (D1) which corresponds to the thickness (D2) of the printed circuit board (1) or differs therefrom by less than 2 %, in particular less than 1 % or 0.5 %.

15. Connection means according to any one of claims 1 to 13, **characterised in that** the thickness (D1) of the contact means (19) is greater than the thickness (D2) of the printed circuit board, the contact means (19) projecting over the respective printed circuit board surface on at least one side of the printed circuit board and preferably on the two opposite sides of the printed circuit board (1).

16. Connection means according to any one of claims 1 to 13, **characterised in that** the thickness (D1) of the contact means (19) is less than the thickness (D2) of the printed circuit board (1), and **in that** the contact means (19) is pressed and/or soldered inside the recess (17) with the circuit board (1) in this recess (17), the diameter or the longitudinal and/or transverse extent of the contact means (19) being greater than the diameter of the screw head (23") and/or the fixing stop (24) formed on the screw shaft (23') or the rivet pin (123) and greater than the diameter or the longitudinal and/or transverse extent of the adjacent region of the holding portion (5, 105).

17. Connection means according to any one of claims 1 to 8, **characterised in that** the contact means (19) is thinner than the printed circuit board (1), and **in that** the screw head (23") which engages in the recess (17) or the fixing stop (24) which engages in the recess (17) and/or the adjacent region of the holding portion (5, 105) which engages in the recess (17) has an external diameter and/or an external contour which dips into the recess (17) at least in part.

18. Connection means according to any one of claims 1 to 17, **characterised in that** the recess (17) for receiving the contact means (19) or the contact element (19') is peripherally enclosed by the material of the printed circuit board (1).

19. Connection means according to any one of claims 1 to 17, **characterised in that** the recess (17) is provided in the edge region (1a) of the printed circuit board (1), the recess (17) only being enclosed by the material of the printed circuit board (1) in a peripheral sub-region and being open towards the printed circuit board (1) on one side (1 a).

20. Connection means according to any one of claims 1 to 17, **characterised in that** the contact means (19) or the contact element (19') is directly electrically connected to an electrically conductive contact portion (7) on the printed circuit board (1) and projects outwards over the edge (1a) of the printed circuit board (1), a contact means portion (19d) which projects over the edge (1a) of the printed circuit board (1) being mechanically fixed and electrically contacted between the fixing stop (24), which projects radially on the screw shaft (23'), and the contact face (11) on the holding portion (5, 105).

21. Connection means according to either claim 19 or claim 20, **characterised in that** the recess (19") is completely enclosed by the material of the contact means (19) or contact element (19'), or is made open to one side in a U-shape or in a U-like manner or with convex shaping.

22. Connection means according to any one of claims 1 to 21, **characterised in that** the fixing stop (24), which projects radially over the screw shaft (23'), is formed on the screw (23) via the underside of the screw head (23").

23. Connection means according to any one of claims 1 to 22, **characterised in that** the connection means is releasable, and for this purpose the screw (23) can be screwed into and out of a hole or threaded hole (13) in the holding portion (5) which is preferably part of the housing (3).

24. Connection means according to any one of claims 1 to 21, **characterised in that** the fixing stop (24), which projects radially over the rivet pin (123), is formed on the rivet pin (123) via the underside of the rivet head (123").

## Revendications

1. Système de connexion électrique pour le montage d'une carte à circuits (1) sur au moins une portion de maintien (5, 105) d'une carte à circuits formant de préférence partie d'un boîtier électriquement conducteur (3), comportant les caractéristiques suivantes :
- un système de contact (19) électriquement conducteur,
- le système de contact (19) électriquement conducteur est relié fermement électriquement et mécaniquement avec une portion de contact (7) électriquement conductrice sur la carte à circuits (1),
- une portion de maintien (5, 105) d'une carte à circuits avec une surface d'appui (11) électriquement conductrice,
- au moins un tronçon du système de contact (19') est fixé mécaniquement et mis en contact électrique entre une butée de fixation (24) qui dépasse radialement par rapport à une tige de vis (23') ou un plot de rivet (123) et la surface d'appui (11) sur la portion de maintien (5, 105) en engendrant une force de serrage agissant sur l'élément de contact (19), et les forces de serrage induites n'agissent pas ou n'agissent pas de manière déterminante sur le matériau de la carte à circuits (1) elle-même,
- le système de contact (19) est en un matériau dont la pression de surface admissible est supérieure à la pression de surface admissible du matériau de la carte à circuits, et
- la pression de surface admissible pour le système de contact (19) est supérieure de plus de 20 % à la pression de surface maximum admissible pour le matériau de la carte à circuits.

2. Système de connexion selon la revendication 1, **caractérisé en ce que** le système de contact (19) est enfoncé à la presse dans un évidement (17) doté d'une métallisation interne (17'), ou brasé dans un évidement (17) rempli de brasure.

3. Système de connexion selon la revendication 1, **caractérisé en ce que** le système de contact (19) réalisé en forme de plaque présente une dimension extérieure qui est supérieure à l'évidement (17) dans la carte à circuits (1), ou **en ce que** le système de contact (19) est ainsi réalisé qu'il dépasse vers l'extérieur au-delà de la bordure (1a) de la carte à circuits (1), et le système de contact (19) en forme de plaque est relié de manière électrique-galvanique, sur la face supérieure ou sur la face inférieure ou encore sur une couche électriquement conductrice intérieure (1b) d'une carte à circuits (1) avec une structure à plusieurs couches, et est également fixé mécaniquement à la carte à circuits (1) via celle-ci.

4. Système de connexion selon l'une des revendications 1 à 3, **caractérisé en ce que** la pression de surface admissible pour le système de contact (19) est supérieure de plus de 20 %, en particulier plus de 40 %, plus de 60 %, plus de 80 %, ou plus de 100 % à la pression de surface maximum admissible pour le matériau de la carte à circuits.

5. Système de connexion selon la revendication 4, **caractérisé en ce que** la pression de surface admissible (p_{adm}) du matériau du système de contact (19) est supérieure à 100 N/mm², de préférence supérieure à 120, supérieure à 140, supérieure à 160, supérieure à 180, et en particulier supérieure à 200 N/mm², de préférence entre 200 N/mm² jusqu'à 600 N/mm².

6. Système de connexion selon l'une des revendications 1 à 5, **caractérisé en ce que**, outre la portion de maintien (5, 105) et la vis (23), ou respectivement la tige de rivet (123), également le système de contact (19) est en métal, en particulier un alliage de métal et en particulier en acier.

7. Système de connexion selon l'une des revendications 1 à 6, **caractérisé en ce que** les forces de précontrainte engendrées par la vis (23) ou par la tige de rivet (123) agissent avec moins de 50 %, en particulier moins de 40 %, 30 %, 20 % et en particulier moins de 10 % sur la carte à circuits.

8. Système de connexion selon l'une des revendications 1 à 5, **caractérisé en ce que** le système de contact (19) est conçu en forme de plaque.

9. Système de connexion selon l'une des revendications 1 à 8, **caractérisé en ce que** le système de contact (19) est pourvu d'un évidement (19") qui est traversé par la tige (23') de la vis.

10. Système de connexion selon la revendication 9, **caractérisé en ce que** le diamètre extérieur du système de contact (19) électriquement conducteur est au moins partiellement légèrement plus grand que le diamètre intérieur correspondant de l'évidement doté de la métallisation intérieure (17').

11. Système de connexion selon la revendication 9, **caractérisé en ce qu'**un moletage (27) ou des surélévations (27a) en forme de nervures ou encore des surélévations planes (27b), disposées par tronçon en décalage les unes par rapport aux autres et de préférence dotées de pentes (27c) en forme de coin en avant en direction d'enfichage, est/sont réalisé(es) à la périphérie extérieure (19a) du système de contact (19).

12. Système de connexion selon l'une des revendications 1 à 10, **caractérisé en ce que** le diamètre ou l'extension longitudinale ou transversale du système de contact (19) est égal(e) ou inférieur(e) au diamètre ou à l'extension longitudinale ou transversale de la portion de maintien (5, 105) réalisée au voisinage de la carte à circuits, et/ou égal(e) ou inférieur(e) au diamètre de la tête de vis (23"), ou encore égal(e) ou inférieur(e) à la butée de fixation (24) reliée à la tige de vis (23').

13. Système de connexion selon l'une des revendications 1 à 10, **caractérisé en ce que** le diamètre ou l'extension longitudinale ou transversale du système de contact (19) est supérieur(e) au diamètre ou à l'extension longitudinale ou transversale de la portion de maintien (5, 105) réalisée au voisinage de la carte à circuits, et/ou supérieur(e) au diamètre de la tête de vis (23 "), ou encore supérieur(e) à la butée de fixation (24) reliée à la tige de vis (23').

14. Système de connexion selon l'une des revendications 1 à 10, **caractérisé en ce que** le système de contact (19) présente une épaisseur (D1) qui correspond à l'épaisseur (D2) de la carte à circuits (1) ou qui en diffère de moins de 2 %, en particulier moins de 1 % ou 0,5 %.

15. Système de connexion selon l'une des revendications 1 à 13, **caractérisé en ce que** l'épaisseur (D1) du système de contact (19) est supérieure à l'épaisseur (D2) de la carte à circuits, et le système de contact (19) dépasse au-delà de la surface respective de la carte à circuits sur au moins un côté de la carte à circuits et de préférence sur les deux côtés opposés de la carte à circuits (à).

16. Système de connexion selon l'une des revendications 1 à 13, **caractérisé en ce que** l'épaisseur (D1) du système de contact (19) est inférieure à l'épaisseur (D2) de la carte à circuits (1), et **en ce que** le système de contact (19) est enfoncé à la presse et/ou brasé avec la carte à circuits (1) à l'intérieur de l'évidement (17), le diamètre ou l'extension longitudinale ou transversale du système de contact (19) étant supérieur(e) au diamètre de la tête de vis (23") et/ou de la butée de fixation (24) réalisée sur la tige de vis (23') ou la tige de rivet (123), et supérieur(e) au diamètre ou à l'extension longitudinale ou transversale de la zone voisine de la portion de maintien (5, 105).

17. Système de connexion selon l'une des revendications 1 à 8, **caractérisé en ce que** le système de contact (19) est plus mince que la carte à circuits (1), et **en ce que** la tête de vis (23") engagée dans l'évidement (17) ou respectivement la butée de fixation (24) engagée dans l'évidement (17) et/ou la zone de la portion de maintien (5, 105) voisine engagée dans l'évidement (17), présente un diamètre extérieur et/ou un contour extérieur qui plonge au moins partiellement dans l'évidement (17).

18. Système de connexion selon l'une des revendications 1 à 17, **caractérisé en ce que** l'évidement (17) destiné à la réception du système de contact (19) ou de l'élément de contact (19') est entouré en périphérie par le matériau de la carte à circuits (1).

19. Système de connexion selon l'une des revendications 1 à 17, **caractérisé en ce que** l'évidement (17) est prévu dans la zone de bordure (1a) de la carte à circuits (1), et l'évidement (17) est entouré par le matériau de la carte à circuits (1) uniquement dans une zone périphérique partielle et est ouvert vers un côté (1a) vers la carte à circuits (1).

20. Système de connexion selon l'une des revendications 1 à 17, **caractérisé en ce que** le système de contact (19) où l'élément de contact (19') est relié électriquement directement avec un tronçon de contact électriquement conducteur (7) sur la carte à circuits (1) et dépasse vers l'extérieur au-delà de la bordure (1a) de la carte à circuits (1), et un tronçon (19b), du système de contact, dépassant au-delà de la bordure (1a) de la carte à circuits (1), est fixé mécaniquement et mis en contact électrique entre la butée de fixation (24) qui dépasse radialement sur la tige de vis (23') et la surface d'appui (11) sur la portion de maintien (5, 105).

21. Système de connexion selon la revendication 19 ou 20, **caractérisé en ce que** l'évidement (19") est entièrement entouré du matériau du système de contact (19) ou de l'élément de contact (19'), ou est conçu en étant ouvert vers un côté en forme de U ou analogue à un U ou encore avec une conformation concave.

22. Système de connexion selon l'une des revendications 1 à 21, **caractérisé en ce que** la butée de fixation (24) qui dépasse radialement au-delà de la tige de vis (23') est formée sur la vis (23) par la face inférieure de la tête de vis (23 ").

23. Système de connexion selon l'une des revendications 1 à 22, **caractérisé en ce que** le système de connexion est détachable, et à cet effet la vis peut être vissée et dévissée dans un perçage ou dans un perçage taraudé (13) dans la portion de maintien (5) qui appartient de préférence au boîtier (3).

24. Système de connexion selon l'une des revendications 1 à 21, **caractérisé en ce que** la butée de fixation (24) qui dépasse radialement au-delà de la tige de rivet (123) est formée sur la tige de rivet (123) par la face inférieure de la tête de rivet (123").
